# EUROPEAN PATENT SPECIFICATION

(11) **EP 4 531 097 B1**
(45) Date of publication and mention of the grant of the patent: **09.12.2026**
(21) Application number: 24202098.0
(22) Date of filing: 24.09.2024
(51) Int. Cl.: H10W 40/22, H10W 40/77, H10W 42/00, H10W 72/20, H10W 72/90, H10W 74/10

(54) **HEAT SINK, SLUG, OR SPREADER AND METHOD OF MANUFACTURING THE SAME**
KÜHLKÖRPER, SCHEIBE ODER STREUER UND VERFAHREN ZU DEREN HERSTELLUNG
DISSIPATEUR THERMIQUE, BOUCHON OU ÉPANDEUR ET SON PROCÉDÉ DE FABRICATION

(30) Priority: 28.09.2023 US 202363586331 P; 19.09.2024 US 202418890514
(43) Date of publication of application: 02.04.2025
(73) Proprietor: STMicroelectronics International N.V., 1228 Plan-les-Ouates, Geneva (CH)
(72) Inventor: DUCA, Roseanne, GXQ 9012 Ghaxaq (MT)
(74) Representative: Casalonga

(56) References cited:
- US-A1- 2019 385 924
- US-A1- 2022 336 321

## Description

### BACKGROUND

### Technical Field

The present disclosure is directed to one or more embodiments of a heat sink, slug, or spreader, and one or more embodiments of a method of manufacturing the same.

### Description of the Related Art

The semiconductor industry has been showing considerable interest in techniques and structures to reduce or prevent effects generated by thermo-mechanical stresses. For example, when a heat sink, slug, or spreader is present on a die of a semiconductor package and there is an increase in temperature in an environment in which the package is present, the heat sink, slug, or spreader may expand when dissipating the thermal energy within the semiconductor package generated by the increase in temperature. Alternatively, when the heat sink, slug, or spreader is present on the die of the semiconductor package and there is a decrease in temperature in the environment in which the package is present, the heat sink, slug, or spreader may contract when dissipating the thermal energy within the semiconductor package generated by the decrease in temperature. While the heat sink, slug, or spreader expands and contracts due to these changes in temperature, the heat sink, slug, or spreader may expand or contract by a differing amount than other components of the semiconductor package due to differences in Coefficients of Thermal Expansion (CTE). These differences in expansion and contraction due to increases and decreases in temperature generates mechanical stresses between the various components of the semiconductor package (e.g., the heat sink, slug, or spreader and the die) resulting in or an increased likelihood in defects propagating within the semiconductor package (e.g., cracking, delamination, or some other similar or like type of defect).

Document US 2019/0385924 A1 discloses a stress buffer layer in an embedded package, and document US 2022/0336321 A1 discloses a manufacturing method of a semiconductor package.

### BRIEF SUMMARY

At least one embodiment of a device *(e.g.,* a semiconductor package, semiconductor device or some other similar or like electronic device) of the present disclosure is directed to a die including a first surface, a second surface opposite to the first surface, and one or more sidewalls transverse to the first surface and the second surface. The one or more sidewalls extend from the first surface to the second surface. A resin covers the one or more sidewalls of the die and extends around the die. A first non-conductive layer is on the second surface of the die. A plurality of conductive vias extend through the first non-conductive layer to the die. A plurality of conductive connection structures is coupled to the plurality of conductive vias and is on the first non-conductive layer. The plurality of conductive connection structures includes a plurality of end surfaces spaced apart from the plurality of conductive vias. A second non-conductive layer is on the first non-conductive layer and extends around the plurality of conductive connection structures. The plurality of end surfaces of the plurality of conductive connection structures is exposed from the second non-conductive layer. A plurality of heat sinks is on the first surface of the die. Each respective heat sink of the plurality of heat sinks being separate and distinct from adjacent heat sinks of the plurality of heat sinks. A plurality of channels separate each respective heat sink of the plurality of heat sinks from adjacent heat sinks of the plurality of heat sinks.

In some embodiments, a second thermally conductive material that is elastic at least partially fills the plurality of channels. The second thermally conductive material is configured to, in operation, increase thermal dissipation of thermal energy.

At least one embodiment of a method of manufacturing is directed to forming the at least one embodiment of the semiconductor package as set forth above.

In view of the above discussion, the embodiments of the present disclosure are directed to preventing, mitigating, or reducing the likelihood of mechanical defects propagating within the semiconductor package including the heat sink, slug, or spreader, which will become readily apparent in view of the discussion herein.

### BRIEF DESCRIPTION OF THE SEVERAL VIEWS OF THE DRAWINGS

For a better understanding of the embodiments, reference will now be made by way of example to the accompanying drawings. In the drawings, identical reference numbers identify the same or similar elements or acts unless the context indicates otherwise. The sizes and relative proportions of the elements in the drawings are not necessarily drawn to scale. For example, some of these elements may be enlarged and positioned to improve drawing legibility.
Figure 1A is a cross-sectional view of a package taken along line 1A-1A as in Figure 1B;
Figure 1B is a top plan view of the package as shown in Figure 1A;
Figure 2A is a cross-sectional view of an embodiment of a package of the present disclosure taken along line 2A-2A as in Figure 2B;
Figure 2B is a top plan view of the embodiment of the package of the present disclosure as shown in Figure 2A;
Figure 3 is a top plan view of an alternative embodiment of a package of the present disclosure;
Figure 4 is a top plan view of an alternative embodiment of a package of the present disclosure;
Figure 5 is a top plan view of an alternative embodiment of a package of the present disclosure;
Figure 6 is a top plan view of an alternative embodiment of a package of the present disclosure;
Figure 7A is a cross-sectional view of an alternative embodiment of a package of the present disclosure taken along line 7A-7A as shown in Figure 7B;
Figure 7B is a top plan view of the alternative embodiment of the package of the present disclosure as shown in Figure 7A;
Figure 8A is a cross-sectional view of an alternative embodiment of a package of the present disclosure taken along line 8A-8A as shown in Figure 8B;
Figure 8B is a top plan view of the alternative embodiment of the package of the present disclosure as shown in Figure 8A;
Figure 9A is a stress map of an interface of a package without a heat sink, slug, or spreader;
Figure 9B is a stress map of an interface within the package as shown in Figures 1A and 1B;
Figure 9C is a stress map of an interface within the embodiment of the package of the present disclosure as shown in Figures 2A and 2B of the present disclosure;
Figure 10 is a flowchart of an embodiment of a method of manufacturing a plurality of heat sinks, slugs, or spreaders of the embodiment of the package of the present disclosure as shown in Figures 2A and 2B;
Figures 11A-11E are cross-sectional views of respective steps of the embodiment method of manufacturing in the flowchart as shown in Figure 10 to manufacture the plurality of heat sinks, slugs, or spreaders of the embodiment of the package of the present disclosure as shown in Figures 2A and 2B;
Figure 12 is a flowchart of an alternative method of manufacturing the plurality of heat sinks, slugs, or spreaders of the alternative embodiment of the package of the present disclosure as shown in Figures 7A and 7B;
Figures 13A-13C are cross-sectional views of respective steps of the embodiment method of manufacturing in the flowchart as shown in Figure 12 to manufacture the plurality of heat sinks, slugs, or spreaders of the embodiment of the package of the present disclosure as shown in Figures 2A and 2B;
Figure 14 is a flowchart of an alternative method of manufacturing the plurality of heat sinks, slugs, or spreaders of the alternative embodiment of the package of the present disclosure as shown in Figures 2A and 2B; and
Figure 15A-15E are cross-sectional views of respective steps of the embodiment method of manufacturing in the flowchart as shown in Figure 14 to manufacture the plurality of heat sinks, slugs, or spreaders of the embodiment of the package of the present disclosure as shown in Figures 2A and 2B.

### DETAILED DESCRIPTION

In the following description, certain details are set forth to provide a thorough understanding of various embodiments of devices, methods, and articles. However, one of skill in the art will understand that other embodiments may be practiced without these details. In other instances, well-known structures and methods associated with, for example, semiconductor fabrication processes, etc., have not been shown or described in detail in some figures to avoid unnecessarily obscuring descriptions of the embodiments.

Unless the context requires otherwise, throughout the specification and claims which follow, the word "comprise" and variations thereof, such as "comprising," and "comprises," are to be construed in an open, inclusive sense, that is, as "including, but not limited to."

Reference throughout this specification to "one embodiment," or "an embodiment" means that a particular feature, structure or characteristic described in connection with the embodiment is included in at least one embodiment. Thus, the appearances of the phrases "in one embodiment," or "in an embodiment" in various places throughout this specification are not necessarily referring to the same embodiment, or to all embodiments. Furthermore, the particular features, structures, or characteristics may be combined in any suitable manner in one or more embodiments to obtain further embodiments.

The sizes and relative positions of elements in the drawings are not necessarily drawn to scale. For example, the shapes of various elements and angles may not be drawn to scale, and some of these elements may be enlarged and positioned to improve drawing legibility.

The use of "transverse" means that a surface, a sidewall, or similar or like structure or feature being at an angle with respect to another respective surface, sidewall, or similar or like respective structure or feature. For example, if a first surface is transverse to a first sidewall, the first surface may be at an angle that is equal to 25-degrees, 35-degrees, 45-degrees, 75-degrees, 90-degrees, 120-degrees, and so forth.

Generally, in semiconductor packages a heat sink, slug, or spreader is coupled to a surface of the package, a surface of a die within the package, or both. The heat sink, slug, or spreader is generally manufactured as continuous layer of thermally conductive material (e.g., copper). This continuous heat sink, slug, or spreader that may be manufactured as a separate component that is later coupled to the surface of the package, the surface of the die, or both. Alternatively, this continuous heat sink may be grown on the surface of the package, the surface of the die, or both. However, as this heat sink, slug, or spreader is manufactured with the continuous layer of conductive material, the thermomechanical stresses generated when the package is exposed to increases or decreases in temperature is high either resulting in the propagation of defects within the package or increasing the likelihood of defects propagating within the package. When defects propagate within the package, the package is generally damaged such that the package will function outside of selected tolerances such that the package becomes defective and needs to be replaced. As there is an increased likelihood of these defects occurring within the package, the overall lifespan of the package is reduced as the increased likelihood of defects occurring only increases as the package is exposed to a greater number of increases and decreases in temperature generating these high thermomechanical stresses. To mitigate these high thermomechanical stresses, the heat sink, slug, or spreader made of the continuous layer of conductive material, the heat sink, slug, or spreader made of the continuous layer of conductive material is manufactured to be as thin as possible. However, there are manufacturing limitations that limit the thinness of the heat sink, slug, or spreader made of the continuous layer of conductive material such that the high thermomechanical stresses can only be mitigated to a certain point by reducing the thickness of the heat sink, slug, or spreader made of the continuous layer of conductive material.

In view of the above discussion, the present disclosure is directed to providing one or more embodiments of a package including a plurality of separate and distinct heat sinks, slugs, or spreaders that are separate and distinct from each other to further mitigate the thermomechanical stresses that occur when the package is exposed to increases or decreases in temperature. For example, the plurality of separate and distinct heat sinks, slugs, or spreaders further mitigate the thermomechanical stresses in the package generated by increases or decreases of temperatures. Further mitigating these thermomechanical stresses by providing the plurality of separate and distinct heat sinks, slugs, or spreaders prevents or further reduces the likelihood of defects propagating within the package. Preventing or further reducing the likelihood of defects by providing the plurality of separate and distinct heat sinks, slugs, or spreaders further increases the usable life span of the package such that the package functions within selected tolerances for a longer period of time as compared to the package including the heat sink, slug, or spreader made of the continuous layer of conductive material.

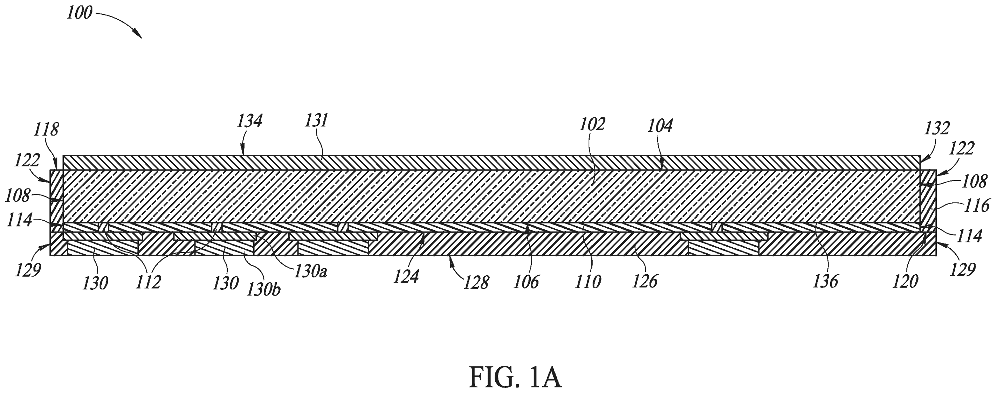

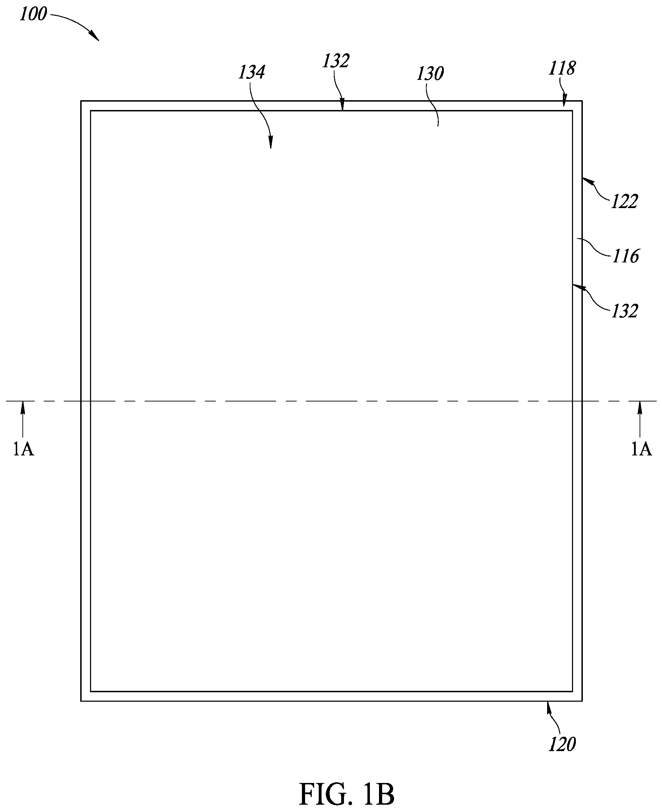

**Figure 1A** is a cross-sectional view of a package 100 taken along line 1A-1A as shown in Figure 1B. **Figure 1B** is a top plan view of the package 100 as shown in Figure 1A.

The package 100 includes a die 102 including a first surface 104, a second surface 106 opposite to the first surface 104, and one or more sidewalls 108 that are transverse to the first surface 104 and the second surface 106. The one or more sidewalls 108 extends from the first surface 104 to the second surface 106.

An insulating, non-conductive, or dielectric layer 110 is on the second surface 106 of the die 102. The dielectric layer 110 may be an ABF. One or more conductive vias 112 extend through the dielectric layer 110. The one or more conductive vias 112 extend through the dielectric layer 110 to the second surface 106 of the die 102. The one or more conductive vias 112 are coupled to contact pads (not shown) of the die 102 along and at the second surface 106 of the die 102. The dielectric layer 110 includes one or more sidewalls 114, which in the package 100 are coplanar with the one or more sidewalls 108 of the die 102.

A resin 116 extends around the die 102 and the dielectric layer 110. The resin 116 is a non-conductive material such as a molding compound, an epoxy compound, or some other similar or like type non-conductive material. The resin 116 covers the one or more sidewalls 108 of the die 102 and covers the one or more sidewalls 114 of the dielectric layer 110. The resin 116 includes a third surface 118, a fourth surface 120 that is opposite to the third surface 118, and one or more sidewalls 122 that are transverse to the third surface 118 and the fourth surface 120. The one or more sidewalls 122 of the resin 116 extend from the third surface 118 to the fourth surface 120. The third surface 118 of the resin 116 is coplanar with the first surface 104 of the die 102, and the fourth surface 120 is coplanar with a surface 124 of the dielectric layer 110.

One or more insulating, non-conductive, or dielectric layers 126 are present on the fourth surface 120 of the resin 116 and on the surface 124 of the dielectric layer 110. While shown as a single layer as shown in Figure 1A, the one or more insulating, non-conductive, or dielectric layers 126 may be a plurality of insulating, non-conductive, or dielectric layers that are stacked on one another. The one or more dielectric layers 126 have a fifth surface 128 that faces away from the die 102. The one or more dielectric layers 126 includes one or more sidewalls 129 that are coplanar with the one or more sidewalls 122 of the resin 116.

One or more conductive connection structures 130 extend through the one or more dielectric layers 126 to the dielectric layer 110. Each one of the one or more conductive connection structures 130 includes a conductive trace 130a and a conductive contact or stud 130b coupled to the corresponding conductive trace 130a. Each respective conductive trace of the one or more conductive traces 130a is coupled to a corresponding conductive via of the one or more conductive vias 112. The one or more conductive connection structures 130 along with the one or more conductive vias 112 provide a pathway for electrical signals to pass into and out of the package 100 and to and from the die 102 within the package 100. For example, the package 100 may be mounted to an external electrical component (e.g., a printed circuit board (PCB)) by utilizing one or more solder balls to interconnect the one or more conductive contacts 130b of the one or more conductive connection structures 130 to the external electrical component.

A heat sink, slug, or spreader 131 is on the first surface 104 of the die 102 and is on the third surface 118 of the resin 116. The heat sink, slug, or spreader 131 is made of a continuous layer of thermally conductive material, which, for example, may be copper or some other suitable type of thermally conductive material. The heat sink 130 includes one or more sidewalls 132 that are spaced inward from the one or more sidewalls 122 of the resin 116. The heat sink 130 includes a sixth surface 134 that faces away from the die 102. The sixth surface 134 is transverse to the one or more sidewalls 132 of the heat sink 130, and the one or more sidewalls 132 of the heat sink 130 extend from the sixth surface 134 to the third surface 118 of the resin 116. The one or more sidewalls 132 of the heat sink 130 being spaced inward from the one or more sidewalls 122 of the resin 116 may be more readily seen in Figure 1B.

As shown in Figure 1B, the package 100 has a rectangular profile when viewed in the top plan view. As shown in Figure 1B, the heat sink 130 has a rectangular profile when viewed in the top plan view.

As the heat sink 130 is a continuous layer of thermally conductive material (e.g., copper), the thermomechanical stresses generated when the package 100 is exposed to increases or decreases in temperature is high either resulting in the propagation of defects (e.g., delamination, cracks, or some other similar or like type of defect) within the package 100 or increasing the likelihood of defects propagating within the package 100. When defects propagate within the package 100, the package 100 is generally damaged such that the package 100 functions outside of selected tolerances such that the package 100 becomes defective and needs to be replaced, disposed of, or thrown out. As there is an increased likelihood of these defects occurring within the package 100, the overall lifespan of the package 100 is reduced as the increased likelihood of defects occurring only increases as the package 100 is exposed to a greater number of increases and decreases in temperature generating these high thermomechanical stresses over the usable life span of the package 100. To mitigate these high thermomechanical stresses, the heat sink 130 made of the continuous layer of thermally conductive material is manufactured to be as thin as possible. However, there are manufacturing limitations that limit the minimum thinness of the heat sink 130 made of the continuous layer of conductive material such that the high thermomechanical stresses can only be mitigated to a certain point by reducing the thickness of the heat sink 130 made of the continuous layer of conductive material.

The defects may further propagate within the package 100 due to differences in coefficients of thermal expansion (CTE) between the various layers and material utilized to form the package 100. For example, the CTE of the heat sink 130 may be substantially different than the CTEs of the die 102 and the dielectric layer 110. This difference in CTEs between the heat sink 130 and the die 102 and the dielectric layer 110 may result in an interface 136 at which the dielectric layer 110 and the die 102 contact each other to begin to crack and delaminate from each other. This cracking within the dielectric layer 110 or delamination between the dielectric layer 110 and the die 102 at this interface 136 may result in damaging the conductive vias 112 present within the dielectric layer 110. When the conductive vias 112 are damaged, respective electrical signals may be inaccurate or unreliable when traveling to and from the die 102 of the package 100.

In view of the above discussion with respect to Figures 1A and 1B, the present disclosure is directed to providing embodiments of a package to further mitigate these thermomechanical stresses to further prevent or reduce the likelihood of defects propagating within the embodiments of the packages of the present disclosure increasing their usable life span.

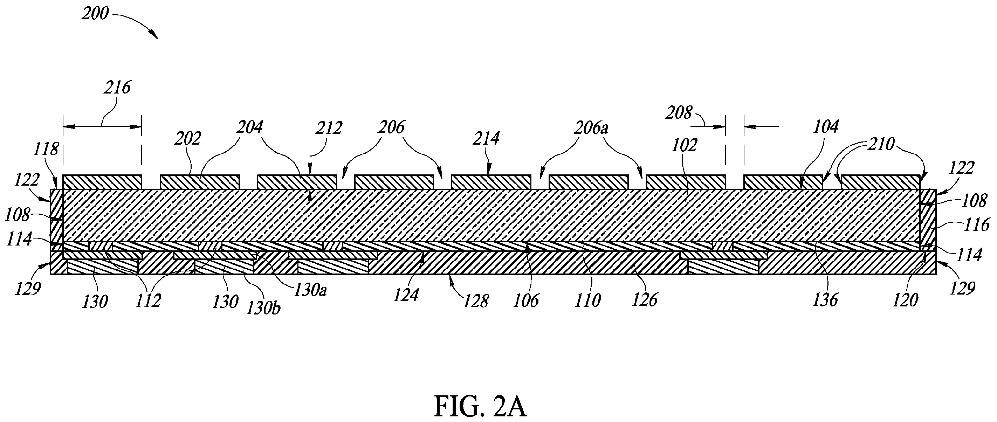

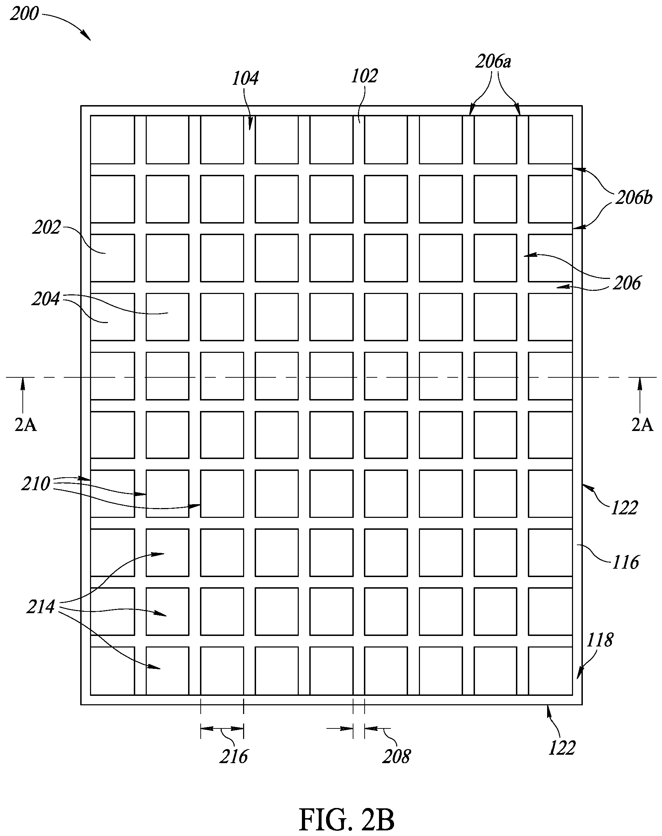

**Figure 2A** is a cross-sectional side view of an embodiment of a package 200 of the present disclosure taken along line 2A-2A as in Figure 2B. **Figure 2B** is a top plan view of the embodiment of the package 200 of the present disclosure as shown in Figure 2A. The same or similar features of the package 200 as compared to the package 100 will be provided with the same or similar reference numerals. In view of these same or similar features between the package 100 as shown in Figures 1A and 1B and the embodiment of the package 200 of the present disclosure as shown in Figures 2A and 2B, for the sake of simplicity and brevity of the present disclosure, the discussion of these same or similar features is not reproduced herein.

Unlike the heat sink, slug, or spreader 131 of the package 100 as shown in Figures 1A and 1B, the package 200 includes a heat sink, slug, or spreader structure 202 including a plurality of separate and distinct heat sinks, slugs, or spreaders 204. Each separate and distinct heat sink of the plurality of separate and distinct heat sinks 204 is separate and distinct from adjacent separate and distinct heat sinks of the plurality of separate and distinct heat sinks 204. The plurality of separate and distinct heat sinks 204 are separated from each other by a plurality of channels, trenches, or recesses 206 that extend through the heat sink structure 202 to the first surface 104 of the die 102. The plurality of channels 206 includes a first group of channels 206a that extends in a first direction and a second group of channels 206b that extends in a second direction transverse to the first direction, which may more readily be seen in Figure 2B of the present disclosure. The first group of channels 206a and the second group of channels 206b extend through and intersect with each other.

As shown in Figure 2B, in this embodiment of the package 100, the first group of channels 206a is transverse to the second group of channels 206b by an angle that is substantially equal to 90 degrees. In other words, in this embodiment of the package 100, the first group of channels 206a is perpendicular or orthogonal to the second group of channels 206b. Based on the orientation of the package as shown in Figure 2B, the first group of channels 206a extends vertically while the second group of channels 206b extends horizontally.

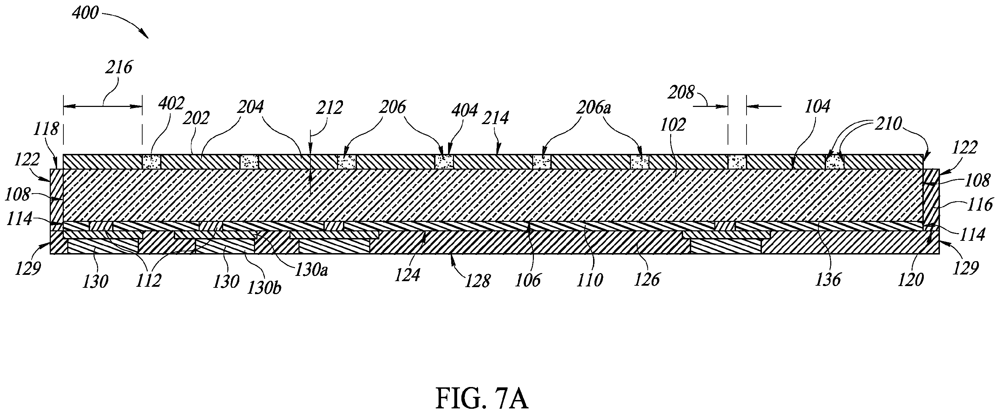

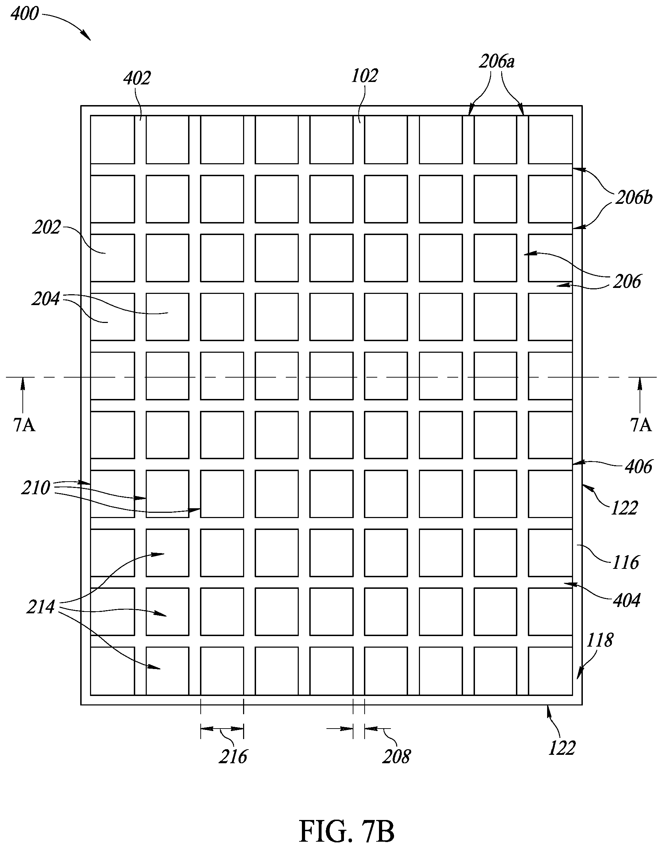

In this embodiment of the package 200, the plurality of channels 206 remains empty. In other words, air is present within the plurality of channels 206. However, in some alternative embodiments, the plurality of channels 206 may be filled with a thermally conductive material with a high elastic modulus (see Figures 7A and 7B of the present disclosure).

As shown in Figure 2B, each respective one of the plurality of separate and distinct heat sinks 204 have a shape of a rectangular prism. In some embodiments, the plurality of separate and distinct heat sinks 204 have a shape of a cuboid.

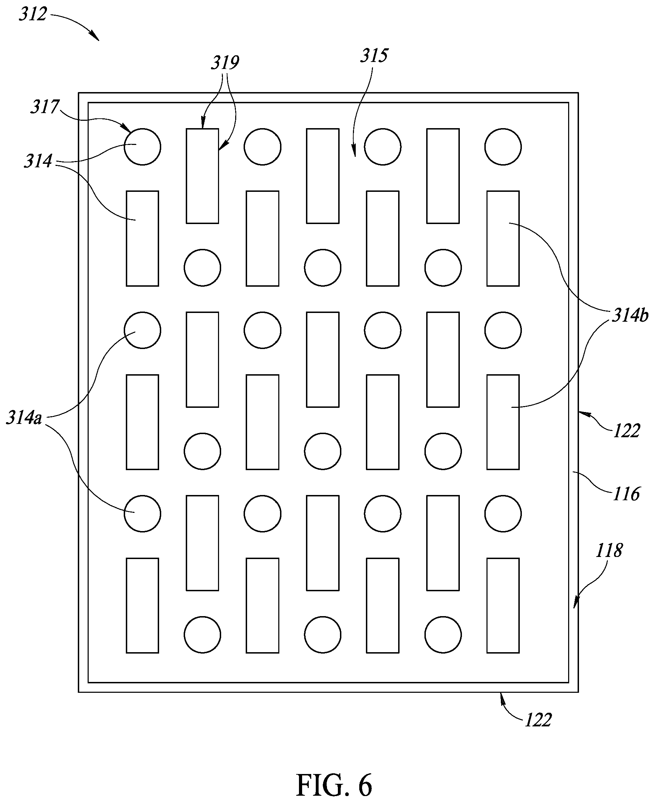

As shown in Figures 2A and 2B, the plurality of separate and distinct heat sinks 204 are all substantially the same size and shape. In some embodiments, the size and shape of the respective heat sinks of the plurality of separate and distinct heat sinks 204 may have different sizes relative to other heat sinks of the plurality of separate and distinct heat sinks 204 (see Figure 6 of the present disclosure). For example, providing different sized and shaped ones of the plurality of separate and distinct heat sinks 204 along the first surface of the die 102 may provide greater mitigation of defects propagating in critical areas within the package 200 in which there is generally a relatively high likelihood of the propagation of defects and may provide lesser mitigation of defects propagating in non-critical areas within the package 200 in which there is generally a relatively low likelihood of propagation of defects.

The respective channels of the plurality of channels 206 have a first dimension 208 *(e.g.,* width of channel) that extends between opposing ones of sidewalls 210 of adjacent heat sinks of the plurality of separate and distinct heat sinks 204. The first dimension 208 ranges from 10 to 350 micrometers (µm) and may be equal to the upper and lower ends of this range. The first dimension 208 is selected based on the situation and environment in which the package 200 will be present to balance mitigating the thermomechanical stresses while providing efficient heat dissipation. Balancing mitigation of the thermomechanical stresses along with the efficiency of heat dissipation of the package 200 depending on the environment in which the package 200 is to be present increases the usable life span of the package 200 such that the life span of the package 200 in that environment is greater than the usable lifespan of the package 100 when in the same environment. The first dimension 208 may also be adjusted based on an amount of space available for the package 200 when mounted or utilized within an electronic device *(e.g.,* a computer, a smartphone, a tablet, or some other similar or suitable type of electronic device).

The respective heat sinks of the plurality of separate and distinct heat sinks 204 have a second dimension (e.g., a thickness) 212 that extends from the first surface 104 of the die 102 to end surfaces 214 of the plurality of separate and distinct heat sinks 204. Each respective heat sink of the plurality of separate and distinct heat sinks 204 extends away from the first surface 104 of the die 102 and terminates at a corresponding end surface of the end surfaces 214 of the plurality of separate and distinct heat sinks 204. The second dimension 212 ranges from 20 to 200 micrometers (µm) and may be equal to the upper and lower ends of this range. Similar to the first dimension 208, the second dimension 212 is selected based on the situation and environment in which the package 200 will be present to balance mitigating the thermomechanical stresses while providing efficient heat dissipation. Balancing mitigation of the thermomechanical stresses along with the efficiency of heat dissipation of the package 200 depending on the environment in which the package 200 is to be present increases the usable life span of the package 200 such that the life span of the package 200 in that environment is greater than the usable lifespan of the package 100 when in the same environment. The second dimension 212 may also be adjusted based on an amount of space available for the package 200 when mounted or utilized within an electronic device *(e.g.,* a computer, a smartphone, a tablet, or some other similar or suitable type of electronic device).

The respective heat sinks of the plurality of separate and distinct heat sinks 204 have a third dimension (e.g., width of heat sink) 216 that extends between opposite sidewalls of the heat sink. The third dimension 216 ranges from 20 to 4000 micrometers (µm) and may be equal to the upper and lower ends of this range. Similar to the first dimension 208 and the second dimension 212, the third dimension 216 is selected based on the situation and environment in which the package 200 will be present to balance mitigating the thermomechanical stresses while providing efficient heat dissipation. Balancing mitigation of the thermomechanical stresses along with the efficiency of heat dissipation of the package 200 depending on the environment in which the package 200 is to be present increases the usable life span of the package 200 such that the life span of the package 200 in that environment is greater than the usable lifespan of the package 100 when in the same environment. The third dimension 216 may also be adjusted based on an amount of space available for the package 200 when mounted or utilized within an electronic device *(e.g.,* a computer, a smartphone, a tablet, or some other similar or suitable type of electronic device).

While the plurality of separate and distinct heat sinks 204 of the package 200 may be similar in thickness (e.g., the second dimension 212) to the heat sink 130 of the package 100, the first dimension 208 and the third dimension 216 may be adjusted and selected to prevent or further reduce the likelihood of defects propagating within the package 200. For example, while the thickness of the heat sink 130 of the package 100 may be only made so thin similar to the plurality of separate and distinct heat sinks 204, the plurality of separate and distinct heat sinks 204 can be further adjusted in size and shape providing greater control and consistency in preventing or further reducing the likelihood of defects propagating within the package 200 as compared to the package 100 when exposed to cyclical increases and decreases of temperature. In other words, the adjustability of the plurality of separate and distinct heat sinks 204 of the package 200 is greater than that of the heat sink 130 of the package 100 resulting in the package 200 having a much lesser likelihood of defects propagating within the package 200 relative to the likelihood of defects propagating within the package 100 when exposed to cyclical increases and decreases in temperature.

The plurality of separate and distinct heat sinks is generally more efficient in dissipating heat away from the package in a controlled fashion as there is a greater number of exposed surfaces *(i.e.,* the end surfaces 214 and the sidewalls 210 of the respective heat sinks of the plurality of separate and distinct heat sinks 204) of the plurality of separate and distinct heat sinks 204 relative to the heat sink 130. In other words, a total surface area exposed when utilizing the plurality of separate and distinct heat sinks 204 is generally greater than that of the heat sink 130. While the total surface area of the exposed plurality of separate and distinct heat sinks 204 is greater, a total volume or area taken up by the plurality of separate and distinct heat sinks 204 is generally equal to or less than a total volume or area taken up by the heat sink 130.

While the thicknesses of the plurality of separate and distinct heat sinks 204 and the heat sink 130 may be similar, the adjustability of the size and shape of the plurality of separate and distinct heat sinks 204 provide greater thermal dissipation and greater control in preventing or reducing the likelihood of defects propagating within the package 200 relative to the package 100 when exposed to cyclical increases and decreases in temperature.

The defects that further propagate within the package 100 due to differences in coefficients of thermal expansion (CTE) between the various layers and material utilized to form the package 100 are mitigated by utilizing the plurality of separate and distinct heat sinks 204 instead of the heat sink 130 made from the continuous layer of thermally conductive material. For example, while the plurality of separate and distinct heat sinks 204 and the heat sink 130 may have the same CTE that is different from the CTEs of the die 102 and the dielectric layer 110, the plurality of separate and distinct heat sinks 204 being separate and distinct from each other and each smaller in size relative to the heat sink 130 more evenly disturbs any difference in expansion and contraction between the plurality of separate and distinct heat sinks 204, the die 102, and the dielectric layer 110 as compared to when the heat sink 130 is instead utilized. This more even distribution of the expansion and contraction due to the individual separate and distinct heat sinks 204 prevents or reduces the likelihood of cracking or delamination at the interface 136. This prevention or reduction of the likelihood of the propagation of defects at the interface 136 increases the usable life span of the package 200 such that the package 200 has a longer usable life span than the package 100.

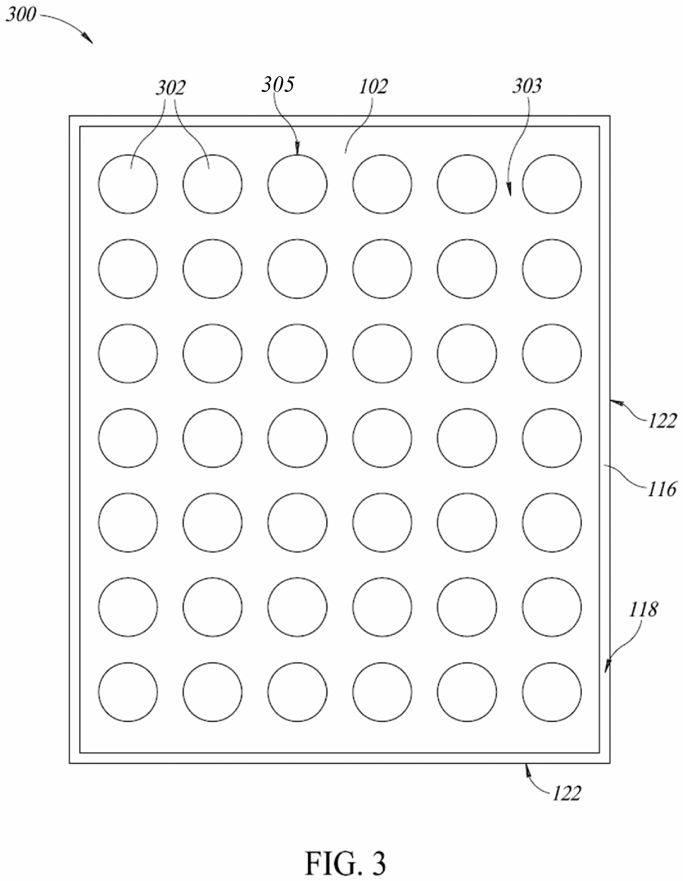

**Figure 3** is directed to a top plan view of an alternative embodiment of a package 300 of the present disclosure. In this embodiment, each one of a plurality of separate and distinct heat sinks 302 have a shape of a cylindrical prism. Each respective heat sink of the plurality of separate and distinct heat sinks 302 is separated from the other respective heat sinks of the plurality of separate and distinct heat sinks 302 by a channel 303. Each of the plurality of separate and distinct heat sinks 302 includes a sidewall 305, which is circular in profile as shown in Figure 3.

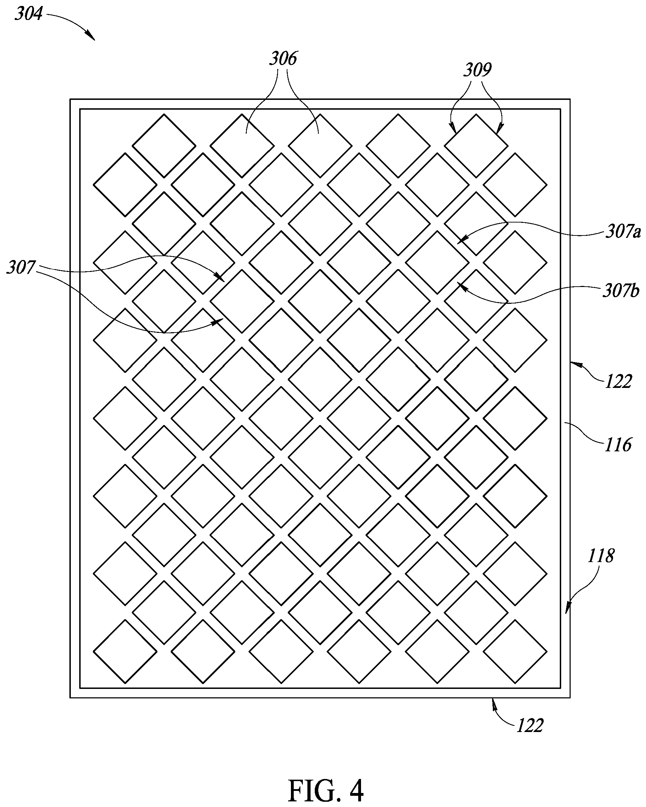

**Figure 4** is directed to a top plan view of an alternative embodiment of a package 304 of the present disclosure. In this embodiment, each one of a plurality of separate and distinct heat sinks 306 have a shape of a diamond prism. Each respective heat sink of the plurality of separate and distinct heat sinks 306 is separated from the other respective heat sinks of the plurality of separate and distinct heat sinks 306 by a plurality of channels 307. The plurality of channels 307 includes a first group of channels 307a and a second group of channels 307b that are transverse to each other and intersect with each other. Based on the orientation as shown in Figure 4, the first and second groups of channels 307a, 307b extend in diagonal directions. Each one of the plurality of separate and distinct heat sinks 306 includes a plurality of sidewalls 309.

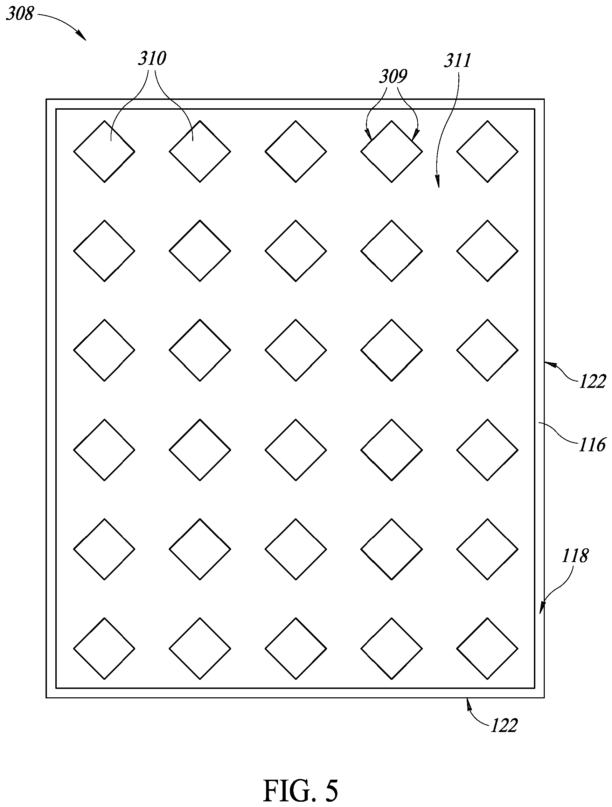

**Figure 5** is directed to a top plan view of an alternative embodiment of a package 308 of the present disclosure. In this embodiment, each one a plurality of separate and distinct heat sinks 310 has a shape of a diamond prism and is oriented slightly differently than as shown in Figure 4 of the present disclosure. Each respective heat sink of the plurality of separate and distinct heat sinks 310 is separated from the other respective heat sinks of the plurality of separate and distinct heat sinks 310 by a channel 311.

**Figure 6** is directed to a top plan view of an alternative embodiment of a package 312 of the present disclosure. In this embodiment, a plurality of separate and distinct heat sinks 314 includes a first group of heat sinks 314a and a second group of heat sinks 314b. The first group of heat sinks 314a has a shape of a cylindrical prism and the second group of heat sinks 314b has a shape of a rectangular prism. Each respective heat sink of the plurality of separate and distinct heat sinks 314 is separated from the other respective heat sinks of the plurality of separate and distinct heat sinks 314 by a channel 315. Each one of the first group of heat sinks 314a includes a sidewall 317, and each one of the second group of heat sinks 314b includes a plurality of sidewalls 319.

As shown in Figures 2A, 2B, 3, 4, 5, and 6, the respective heat sinks of the plurality of separate and distinct heat sinks 204, 302, 306, 310, 314 are arranged in an array along the first surface 104 of the die 102. In view of the various embodiments of the packages 200, 300, 304, 308, 312 of the present disclosure, the orientation and positioning of the respective heat sinks of the plurality of separate and distinct heat sinks 204, 302, 306, 310, 314 may be further adjusted or selected to further prevent or mitigate the propagation of defects within the various embodiments of the packages 200, 300, 304, 308, 312 of the present disclosure while providing ample heat dissipation at the same time.

**Figure 7A** is directed to a cross-sectional of an alternative embodiment of a package 400 taken along line 7A-7A as shown in Figure 7B. **Figure 7B** is directed to a top plan view of the alternative embodiment to the package 400 as shown in Figure 7A.

The package 400 includes a thermally conductive material 402 filling the plurality of channels 206. The same or similar features of the package 400 as compared to the packages 100, 200, respectively, will be provided with the same or similar reference numerals. In view of these same or similar features between the packages 100, 200, respectively, as shown in Figures 1A, 1B, 2A, and 2B, respectively, and the embodiment of the package 400 of the present disclosure as shown in Figures 7A and 7B, for the sake of simplicity and brevity of the present disclosure, the discussion of these same or similar features is not reproduced herein.

The thermally conductive material 402 is present within the plurality of channels 206 and either partially or fully fills the plurality of channels 206 as shown in Figure 7A. The thermally conductive material 402 may be a soft material *(i.e.,* has a high modulus of elasticity) that is thermally conductive to further facilitate heat dissipation while having minimal or no effect on the generation of thermomechanical stresses present within the package 400 when exposed to cyclical increases and decreases in temperature. The thermally conductive material 402 covers the sidewalls 210 of the plurality of separate and distinct heat sinks 204. In this embodiment of the package 400, the thermally conductive material 402 fully fills the plurality of channels 206 such that the thermally conductive material has a surface 404 that is coplanar with the end surfaces 214 of the plurality of separate plurality of separate and distinct heat sinks 204. In this embodiment of the package 400, the thermally conductive material 402 includes one or more end sidewalls 406 that are coplanar with the sidewalls 210 of respective heat sinks of the plurality of separate and distinct heat sinks 204 that are at a peripheral region or edge of the heat sink structure 202. In other words, in this embodiment of the package 400, the thermally conductive material 402 is not present on the third surface 118 of the resin 116 as shown in Figure 7B. The one or more end sidewalls 406 of the thermally conductive material 402 are spaced inward from the one or more sidewalls 122 of the resin 116.

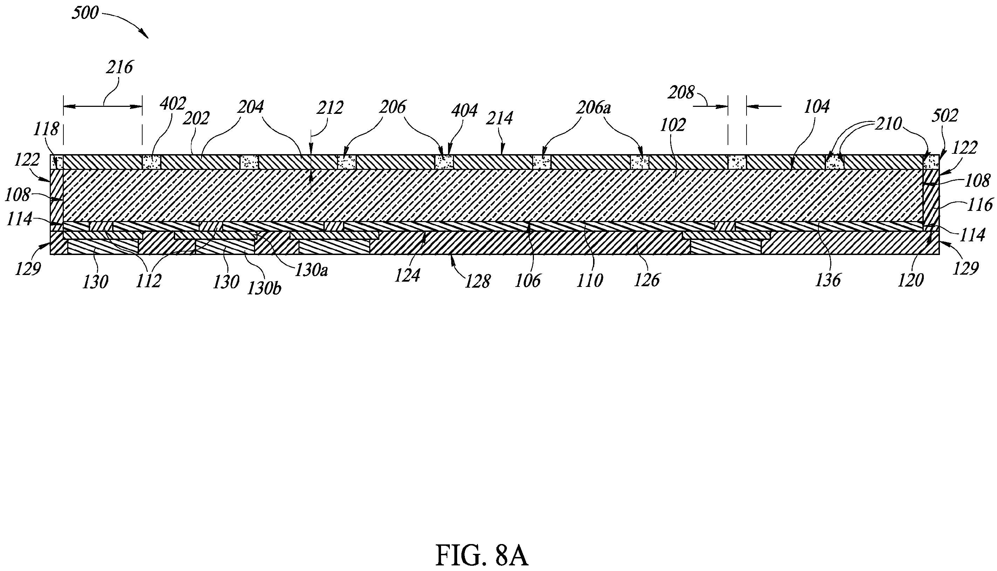

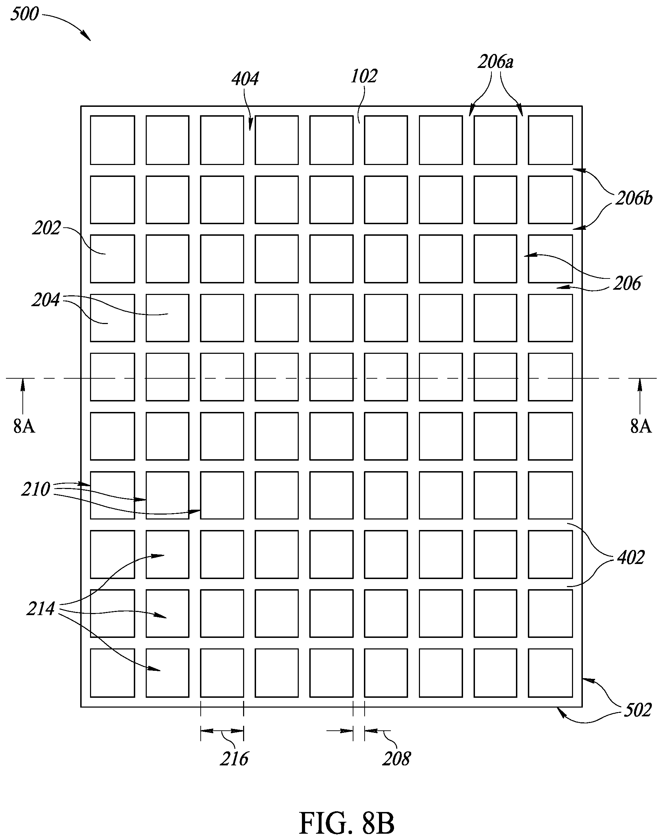

**Figure 8A** is a cross-sectional view of an alternative embodiment of a package 500 of the present disclosure taken along line 8A-8A as shown in Figure 8B. Figure 8B is directed to a top plan view of an alternative embodiment of a package 500. The package 500 is essentially the same as the package 400 except that the thermally conductive material 402 is present on the third surface of the resin 116 and the thermally conductive material 402 covers the sidewalls 210 of the respective heat sinks of the plurality of separate and distinct heat sinks 204 at the peripheral region or edge of the heat sink structure 202. In this embodiment of the package 500, the thermally conductive material 402 includes one or more sidewalls 502 that are coplanar with the sidewalls 122 of the resin 116.

The thermally conductive material 402 may have a modulus of elasticity within the range of 0.1 to 5000 MPa *(e.g.,* Megapascals) and may be equal to the upper and lower ends of this range. For example, the thermally conductive material 402 may be silicones, epoxies, pastes, or some other similar or suitable type of material that is soft and elastic such that it readily deforms when placed under compression or tension. These various materials may be more elastic or less elastic depending on the situation or environment in which the final package may be utilized.

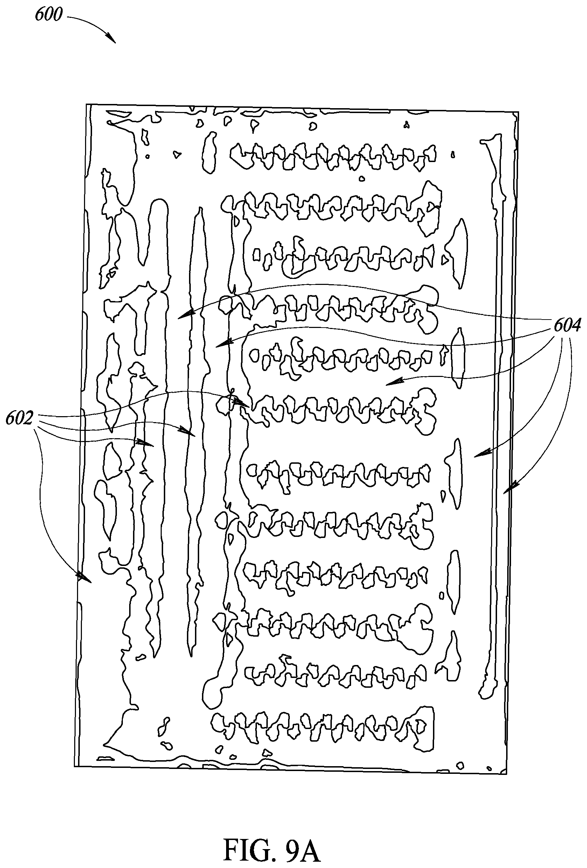

**Figure 9A** is a top plan view of a stress map 600 at the interface 136 of the package 100 when the package 100 does not include the heat sink 130. As discussed earlier herein, the interface 136 is the location at which the die 102 *(e.g.,* silicon die) and the dielectric layer *(e.g.,* ABF layer or film) contact each other. The stress map 600 is representative of thermomechanical stresses generated at the interface when cooling down from a first temperature to second temperature. The first temperature is greater than the second temperature such that, for example, the first temperature is a maximum temperature when the package 100 is in use and the second temperature is a room temperature (e.g., in some instances, room temperature may be within the range of 15 to 25 degrees Celsius or equal to the upper and lower ends of this range). As shown in the stress map 600, there are high stress regions 602 and low stress regions 604. As shown in the stress map 600, the low stress regions 604 are larger than the low stress regions 604 such that there is a low likelihood of defects propagating due to thermomechanical stresses. However, when the package 100 does not include the heat sink 130, the package 100 cannot easily and quickly dissipate the thermal energy such that the components within the package 100 may deteriorate more quickly over time due to the slow speed that the package 100 without the heat sink 130 takes to cool down from the first temperature to the second temperature.

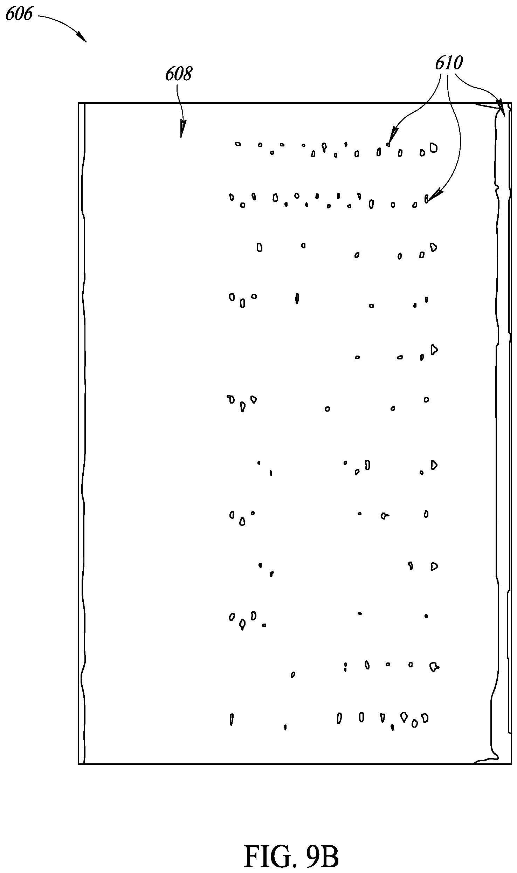

**Figure 9B** is a top plan view of a stress map 606 at the interface 136 of the package 100 when the package 100 does include the heat sink 130. As discussed earlier herein, the interface 136 is the location at which the die 102 *(e.g.,* silicon die) and the dielectric layer *(e.g.,* ABF layer or film) contact each other. The stress map 606 is representative of thermomechanical stresses generated at the interface when cooling down from a first temperature to second temperature. The first temperature is greater than the second temperature. For example, in some instances, the first temperature is a maximum temperature when the package 100 is in use and the second temperature is a room temperature (e.g., in some instances, room temperature may be within the range of 15 to 25 degrees Celsius or equal to the upper and lower ends of this range). As shown in the stress map 606, there is a high stress region 608 and low stress regions 610. The high stress regions 602 in the stress map 600 are much smaller than the high stress region 608 in the stress map 606, and the low stress regions 604 in the stress map 600 are much larger than the low stress regions 610 in the stress map 606. In view of this, while there may be good heat dissipation by the presence of the heat sink 130 fully covering the first surface 104 of the die 102, there is a high likelihood of defects (e.g., cracking, delamination, shearing, etc.) occurring at the interface 136 due to the large high stress region 608, which is along the majority of the interface 136. When the heat sink 130 is present on the first surface 130 of the die 102, there is a 16% increase in the thermomechanical stresses that occur at the interface 136 as compared to when the package 100 does not include the heat sink 130. However, as discussed above, the heat sink 130 allows for the package to dissipate heat much more quickly and efficiently than when the heat sink is not present.

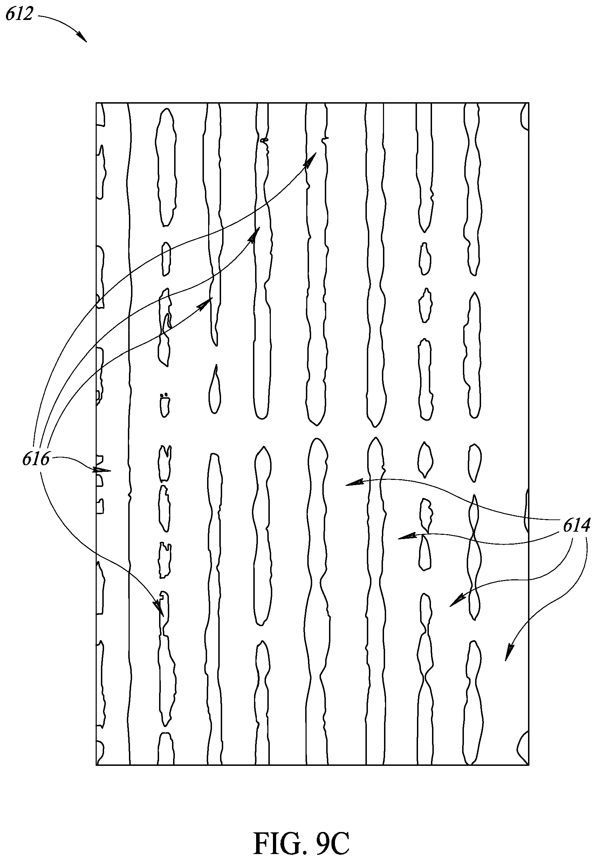

**Figure 9C** is a top plan view of a stress map 612 for the package 200 that includes the plurality of separate and distinct heat sinks 204. As discussed earlier herein, the interface 136 is the location at which the die 102 *(e.g.,* silicon die) and the dielectric layer *(e.g.,* ABF layer or film) contact each other. The stress map 612 is representative of thermomechanical stresses generated at the interface when cooling down from a first temperature to second temperature. The first temperature is greater than the second temperature. For example, in some instances, the first temperature is a maximum temperature when the package 100 is in use and the second temperature is a room temperature (e.g., in some instances, room temperature may be within the range of 15 to 25 degrees Celsius or equal to the upper and lower ends of this range). As shown in the stress map 612, there are high stress regions 614 and low stress regions 616, and the high stress regions 614 and the low stress regions 616 are both evenly distributed across and along the interface 136 within the package 200. The high stress regions 614 in the stress map 612 are smaller than the high stress region 608 in the stress map 606 and are larger than the high stress regions 602 in the stress map 600, and the low stress regions 616 in the stress map 612 are larger than the low stress regions 610 in the stress map 606 and smaller than the low stress regions 604 in the stress map 600. When the plurality of separate and distinct heat sinks 204 are present on the first surface 104 of the die 102, there is a 6.5% decrease in the thermomechanical stresses that occur at the interface 136 as compared to when the package 100 includes the heat sink 130. In view of this, the plurality of separate and distinct heat sinks 204 being present at the first surface 104 of the die 102 of the package 200 maintain good heat dissipation such that the package cools down relatively quickly from the first temperature to the second temperature while at the same time preventing or reducing the likelihood of defects propagating along the interface 136. The propagation of defects along the interface 136 is prevented or reduced in likelihood as the high stress regions 614 and the low stress regions 616 are evenly distributed across the interface, the high stress regions 614 are smaller than the high stress region 608, and the low stress regions 616 are larger than the low stress regions 610. In view of this, the package 200 with the plurality of separate and distinct heat sinks 204 not only provides good heat dissipation that is the same or similar to package 100 with the heat sink 130, the plurality of separate and distinct heat sinks 204 of the package 200 prevent or reduce thermomechanical stresses at the interface 136 as compared to the package 100 with the heat sink 130. This good heat dissipation and further prevention or reduction in thermomechanical stresses at the interface 136 results in the package 200 with the plurality of separate and distinct heat sinks 204 having a longer usable life span than the package 100 with the heat sink 130.

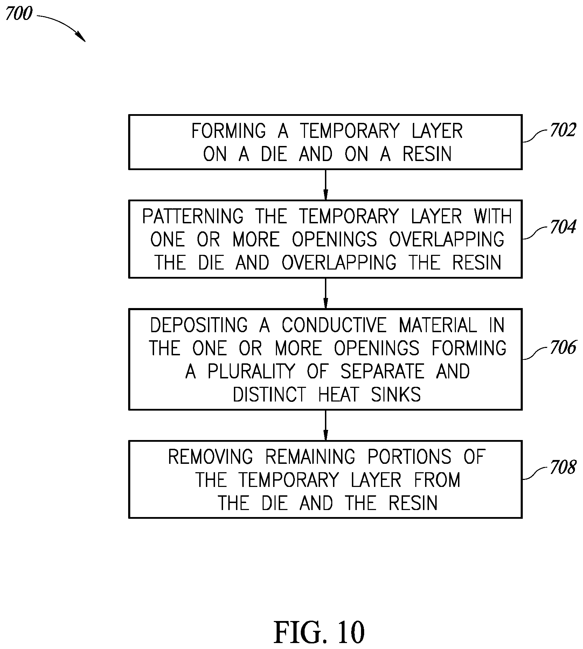

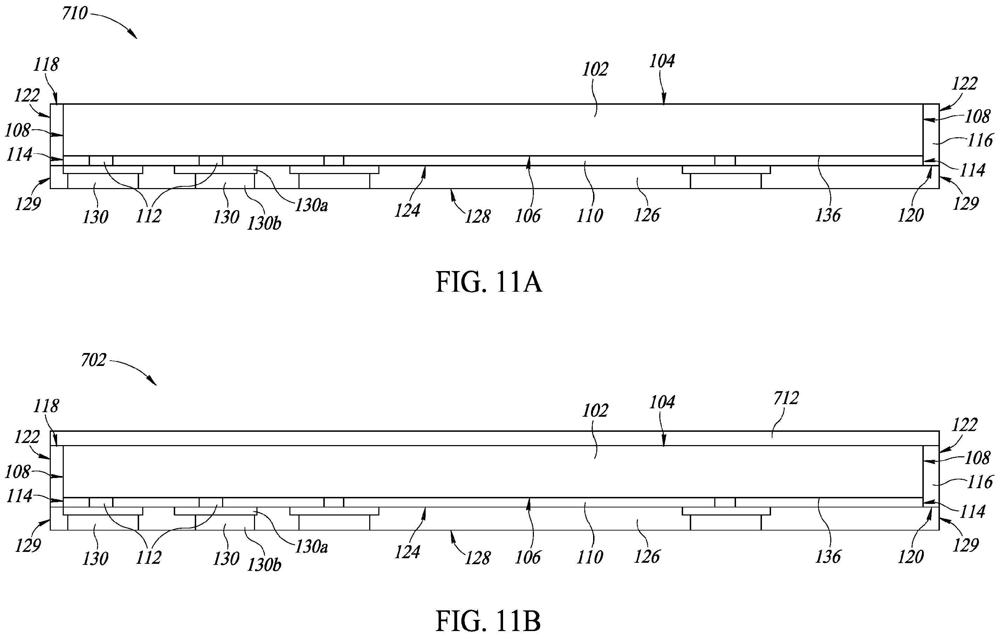

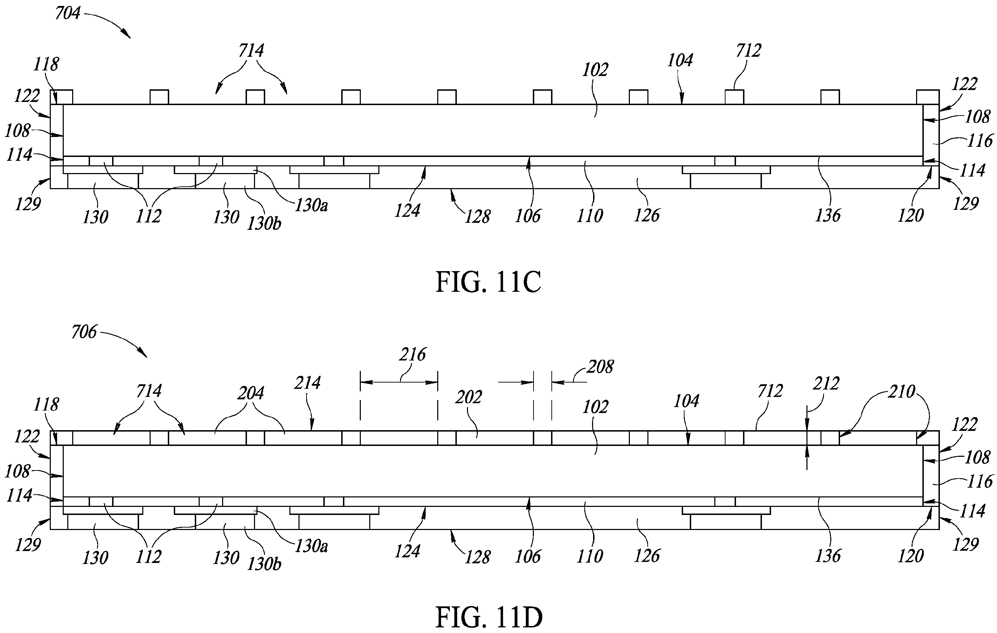

**Figure 10** is a flowchart 700 of a method of manufacturing the embodiment of the package as shown in Figures 2A and 2B of the present disclosure. The flowchart 700 of the method of manufacturing includes a first step 702, a second step 704, a third step 706, and a fourth step 708. Figures 11A-11E are cross-sectional views of the respective steps of the flowchart 700, which will be discussed in detail as follows herein in tandem with the respective steps of the flowchart 700.

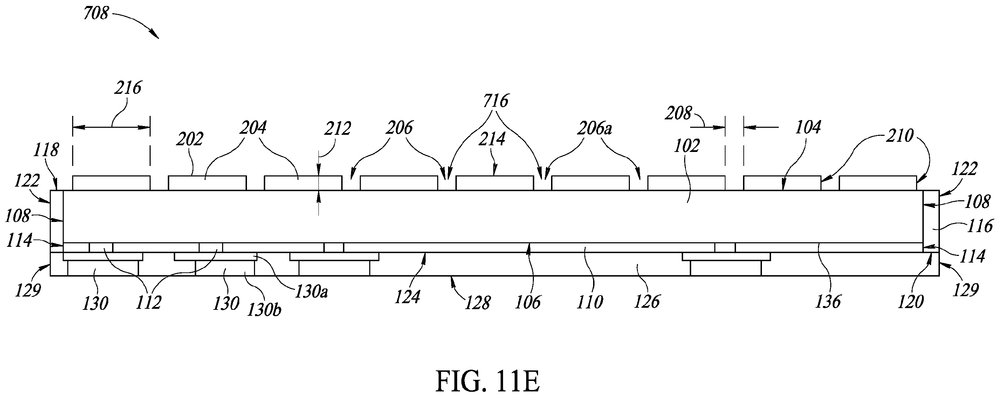

As shown in **Figure 11E****,** an assembly 710 has been manufactured including the one or more dielectric layers 126, the one or more conductive connection structures 130, the dielectric layer 110, the conductive vias 112, and the resin 116. In other words, the assembly 710 is a partially manufactured version of the package 200 that has undergone processes and techniques within the semiconductor industry to form the assembly 710.

In the first step as shown in **Figure 11B****,** a temporary layer 712 is formed on the first surface 104 of the die 102 and the third surface 118 of the resin 116. In some embodiments, the temporary layer 712 may be a single layer such that the temporary layer 712 is a mask layer or a photoresist layer that is capable of being patterned or etched. In some alternative embodiments, the temporary layer 712 may be one or more stacked layers such that the temporary layer is one or more mask layers or photoresist layers that are capable of being patterned or etched.

After the first step 702 in which the temporary layer 712 is formed on the first surface 104 of the die 102 and the third surface 118 of the resin 116, in the second step 704 the temporary layer 712 is etched *(e.g.,* chemical etching) or patterned *(e.g.,* exposure to light, drilling, cutting, etc.) to form one or more openings 714 within the temporary layer 712 exposing regions or areas of the first surface 104 of the die 102. The one or more openings 714 may be formed to be rectangular shaped openings, circular shaped openings, diamond shaped openings, or some other size or shape as to form heat sinks with that corresponding size and shape.

After the second step 704 in which the one or more openings 714 are formed in the temporary layer 712, in the third step 706 a thermally conductive material is formed by being deposited into the one or more openings 714. The thermally conductive material may be a copper material or some other suitable thermally conductive material. After the thermally conductive material is formed by being deposited into the one or more openings 714, the thermally conductive material is allowed to cure forming the plurality of separate and distinct heat sinks 204.

After the third step 706 in which the plurality of separate and distinct heat sinks 204 are formed on the first surface 104 of the die 102, in the fourth step 708 any remaining portions of the temporary layer 712 are removed. For example, the temporary layer 712 may be made of a material that deteriorates and dissolves when exposed to a fluid such as water or may be made of a material that deteriorates and dissolves when exposed to light. Once the remaining portions of the temporary layer 712 are removed, regions 716 of the first surface 104 of the die 102 are exposed and the third surface 118 of the resin 116 is exposed. Removing these remaining portions of the temporary layer 712 defines the plurality of channels 206 between the plurality of separate and distinct heat sinks 204. In other words, the package 200 has been manufactured after the fourth step 708.

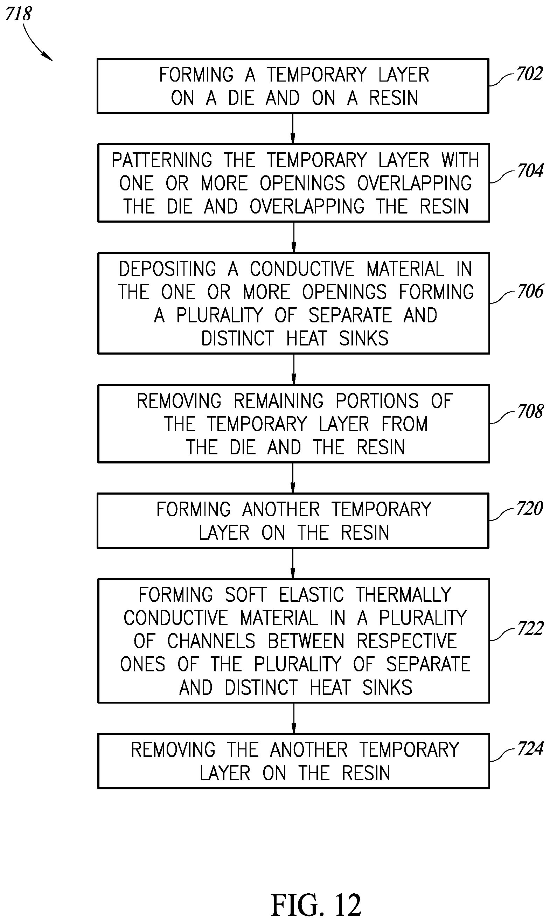

**Figure 12** is a flowchart 718 of a method of manufacturing the plurality of heat sinks, slugs, or spreaders 204 of the alternative embodiment of the package 400 along with forming the thermally conductive material 402 with the high modulus of elasticity. The flowchart 718 includes the first step 702, the second step 704, the third step 706, and the fourth step 708. As the first, second, third, and fourth steps 702, 704, 706, and 708 have been described in detail above with respect to Figures 10 and 11A-11E, the discussion of the first, second, third, and fourth steps 702, 704, 706, 708 is not reproduced herein. The flowchart 718 further includes a fifth step 720, a sixth step 722, and a seventh step 724.

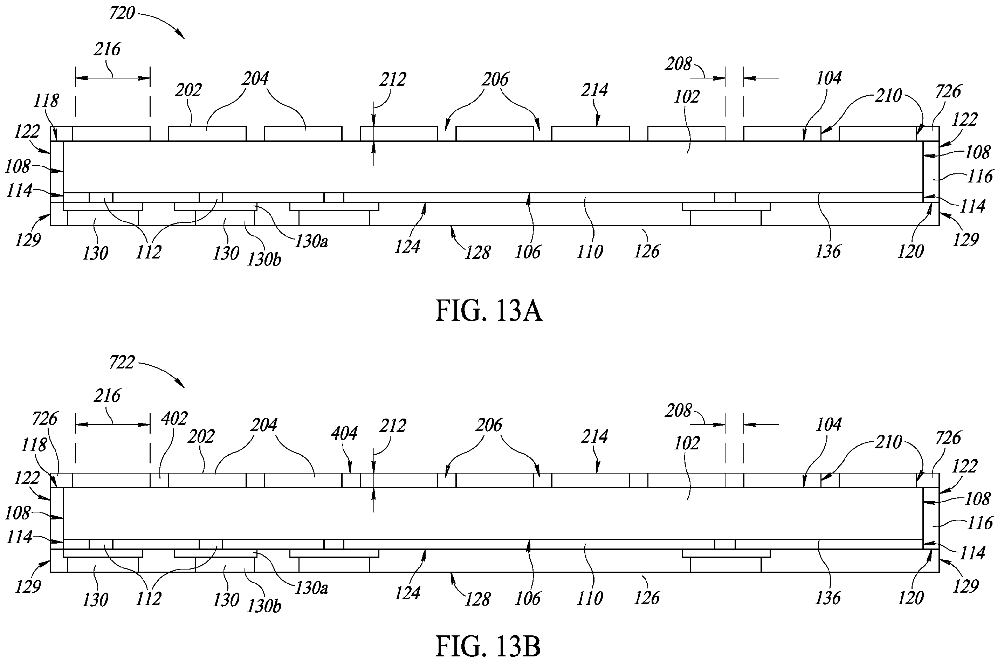

In the fifth step 720, another temporary layer 726 is formed on the third surface 118 of the resin 116. In some embodiments, the another temporary layer 726 may be partially formed on the first surface 104 of the die 102 depending on whether respective heat sinks of the plurality of separate and distinct heat sinks 204 at the peripheral region of the heat sink structure 202 are spaced inward from the one or more sidewalls 108 of the die 102. As shown in **Figure 13A****,** the another temporary layer 726 covers the third surface 118 of the resin 116. In some embodiments, while not shown, one or more additional temporary layers (not shown) may be formed on and along the plurality of separate distinct heat sinks 204 and in the plurality of channels 206 to avoid forming the another temporary layer 726 on and along the plurality of separate and distinct heat sinks 204 and in the plurality of channels 206. After being formed, the one or more additional temporary layers (not shown) may be patterned with openings to expose regions at which the another temporary layer 726 is to be formed. Once the one or more additional temporary layers (not shown) are patterned, the another temporary layer 726 is formed at the exposed regions exposed by the openings in the one or more additional temporary layers. Once the another temporary layer 726 is formed at the exposed regions, the one or more additional temporary layers (not shown) are removed exposing the plurality of separate and distinct heat sinks 204 and the plurality of channels 206 such that the remaining structure as shown in Figure 13A is formed. The one or more additional temporary layers may be a soluble material that deteriorates or dissolves when exposed to a liquid or gas, or may deteriorate and dissolve when exposed to a light source.

After the fifth step 720 in which the another temporary layer 726 is formed as shown in Figure 13A, in the sixth step 722 the plurality of channels 206 are filled with the thermally conductive material 402 with the high modulus of elasticity. The thermally conductive material 402 with the high modulus of elasticity is soft and elastically deformable. In some embodiments, while not shown, one or more additional temporary layers (not shown) are formed on the plurality of separate and distinct heat sinks, on the another temporary layer 726, and in the plurality of channels 206. Once the one or more additional temporary layers (not shown) are formed, the one or more additional temporary layers (not shown) are patterned with openings to expose the plurality of channels 206 and the regions 716 of the first surface of the die 102. After patterning the one or more additional temporary layers (not shown), the thermally conductive material 402 is formed in the plurality of channels 206 and the regions 716 exposed by the openings in the one or more additional temporary layers (not shown). Once the thermally conductive material 402 is formed within the plurality of channels 206 and on the regions 716, the one or more additional temporary layers (not shown) are removed resulting in the remaining structure as shown in **Figure 13B****.** The one or more additional temporary layers may be a soluble material that deteriorates or dissolves when exposed to a liquid or gas, or may deteriorate and dissolve when exposed to a light source. Once the thermally conductive material 402 is formed in the plurality of channels 206 and on the regions 716, the one or more sidewalls 210 of the plurality of separate and distinct heat sinks 204 are covered by the thermally conductive material 402.

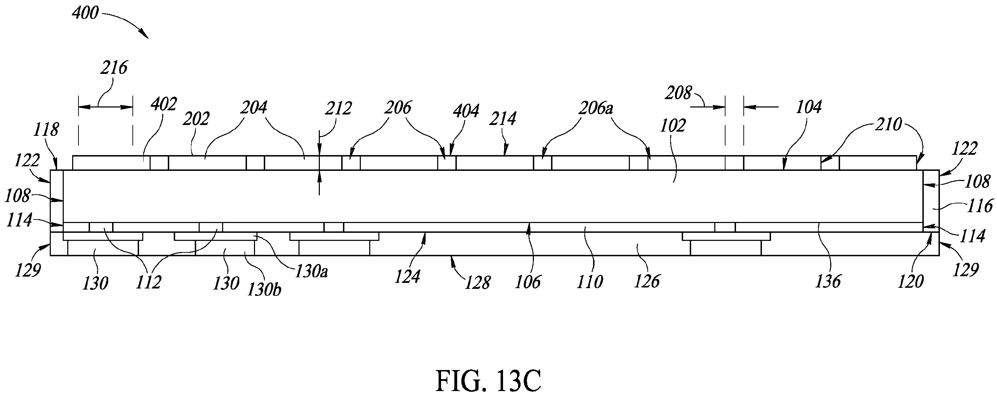

After the sixth step 722 in which the thermally conductive material 402 is formed within the plurality of channels 206 and on the regions 716, in the seventh step 724 the another temporary layer 726 is removed. The another temporary layer 726 may be a material that is soluble when exposed to a liquid or gas, or may deteriorate and dissolve when exposed to the light source. Once the another temporary layer 726 is removed, the structure remaining as shown in **Figure 13C** has been manufactured. In other words, the package 400 has been manufactured after the seventh step 724.

The package 500 may be formed by not forming the another temporary layer 726 in the fifth step 720 and, instead, simply by proceeding to the seventh step 724. By not performing the sixth step 722, the third surface 118 of the resin 116 remains exposed such that the thermally conductive material 402 is formed on the third surface 118 of the resin 116 manufacturing the package 500.

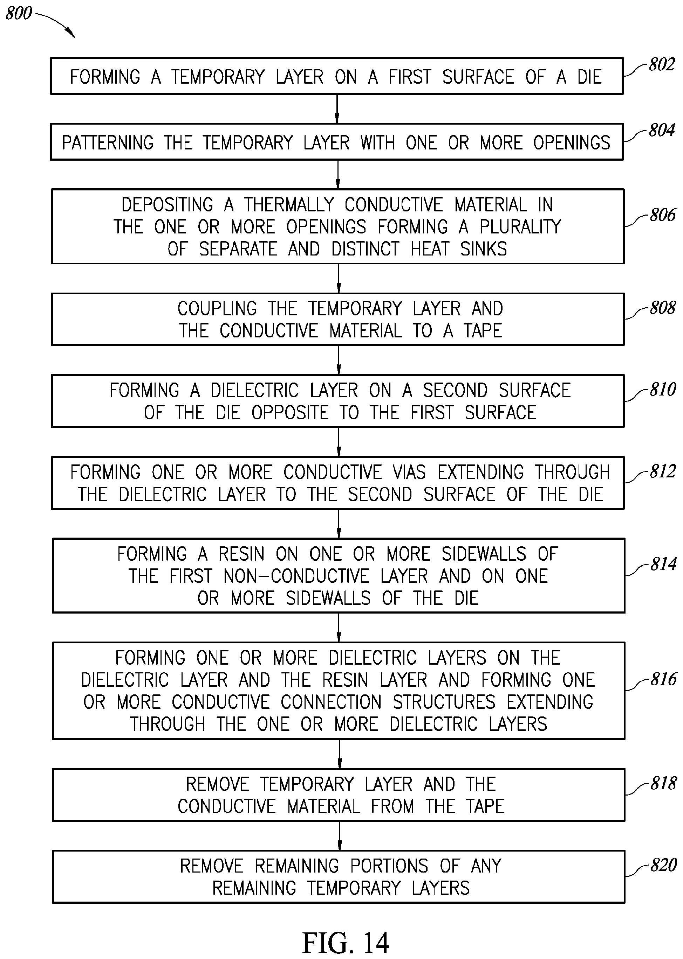

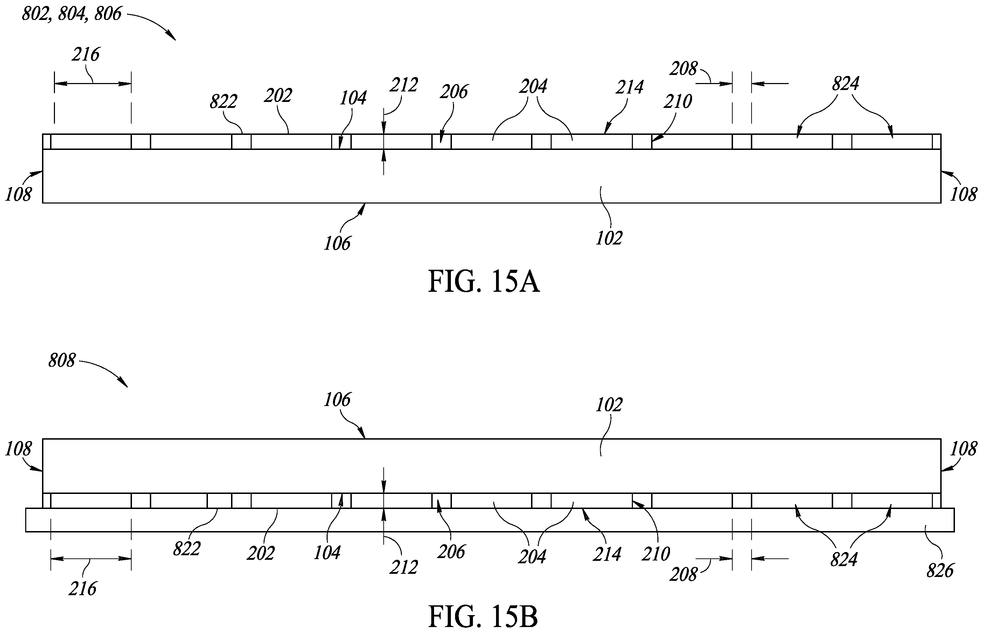

**Figure 14** is a flowchart 800 of an alternative method of manufacturing the embodiment of the package 200 of the present disclosure as shown in Figures 2A and 2B of the present disclosure. The flowchart 800 of the alternative method of manufacturing the embodiment of the package 200 includes a first step 802, a second step 804, a third step 806, a fourth step 808, a fifth step 810, a sixth step 812, a seventh step 814, an eighth step 816, a ninth step 818, and a tenth step 820. Figures 15A-15E are cross-sectional views of the respective steps of the flowchart 800, which will be discussed in detail as follows herein in tandem with the respective steps of the flowchart 800.

In the first step 802, a temporary layer 822 is formed on the first surface 104 of the die 102. After the first step 802 in which the temporary layer 822 is formed on the first surface of the die 102, in the second step 804 the temporary layer 822 is patterned with one or more openings 824. The openings 824 may be formed within the temporary layer 822 by drilling, etching (chemical etching, water etching, photoresist etching, etc.) or some other suitable type of technique for forming the one or more openings 824 in the temporary layer 822. After the one or more openings 824 are formed in the temporary layer 822, in the third step 806 a thermally conductive material is deposited into the one or more openings 824. The thermally conductive material is then allowed to cure and harden such that the plurality of separate and distinct heat sinks 204 are formed within the one or more openings 824 patterned within the temporary layer 822. The results of the first step 802, the second step 804, and the third step 806 may be readily seen in the cross-sectional view of the structure as shown in **Figure 15A****.**

After the third step 806 in which the plurality of separate and distinct heat sinks 204 are formed within the one or more openings 824 patterned within the temporary layer 822, in the fourth step 808, the structure as shown in Figure 15A is flipped such that the temporary layer 822 and the end surface 214 of the plurality of separate and distinct heat sinks 204 are temporarily coupled to a support 826. For example, the support 826 may be a tape, a dummy wafer, or some other suitable type of support 826 to which the end surfaces 214 of the plurality of separate and distinct heat sinks 204 and the temporary layer 822 may be temporarily coupled to by an adhesive. The results of the fourth step 808 may be readily seen in the cross-sectional view of the structure as shown in **Figure 15B****.**

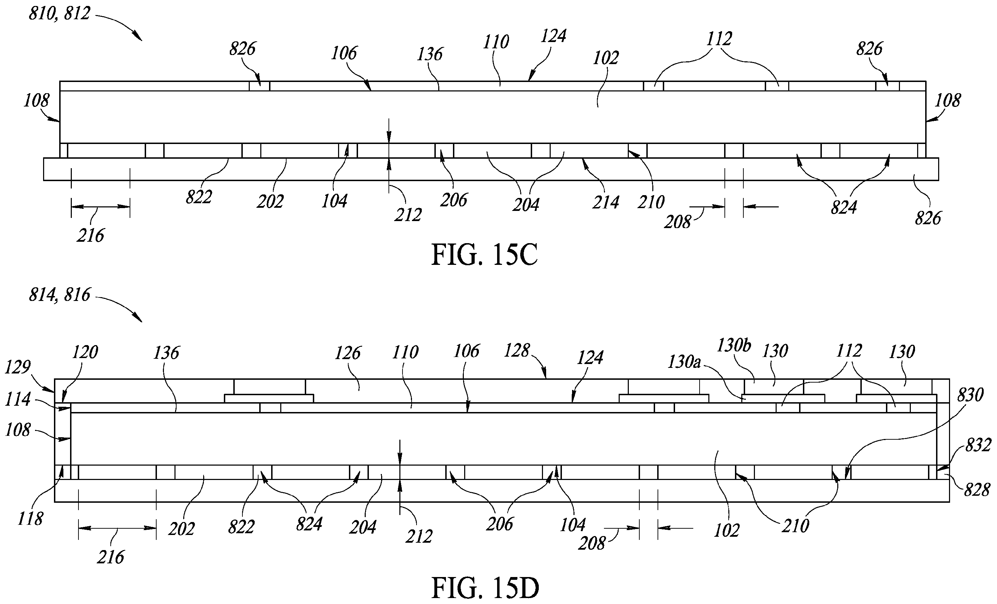

After the fourth step 808 in which the end surfaces 214 of the plurality of separate and distinct heat sinks 204 and the temporary layer 822 are temporarily coupled to the support 826, in the fifth step 810 the dielectric layer 110, which may be an ABF layer or film, is formed on the second surface 106 of the die 102. After the fifth step 810 in which the dielectric layer 110 is formed on the second surface 106 of the die 102, in the sixth step 812 one or more openings 826 are patterned within the dielectric layer 110. After the dielectric layer 110 has been patterned with the one or more openings, a conductive material is formed within the one or more openings 826 and allowed to cure forming the conductive vias 112 within the dielectric layer 110. The results of the fifth step 810 and the sixth step 812 may readily be seen in the cross-sectional view of the structure as shown in **Figure 15C****.**

After the sixth step 812 in which the dielectric layer 110 is formed on the second surface 106 of the die 102 and the conductive vias 112 are formed extending through the dielectric layer 110 to the second surface 106 of the die 102, in the seventh step 814 the resin 116 is formed on the one or more sidewalls 108 of the die 102 and on the one or more sidewalls 114 of the dielectric layer 110. In this embodiment of the method of manufacturing the package 200 with the flowchart 800, in advance of forming the resin 116, an additional temporary layer 828 is formed on a surface 830 of the support 826 and on one or more sidewalls of the temporary layer 832 (see **Figure 15D****).** The formation of this additional temporary layer 828 prevents the resin 116 from extending past the first surface 104 of the die 102. In some alternative embodiments of methods of manufacturing the package 200, this additional temporary layer 828 may not be formed such that the resin 116 extends past the first surface 104 of the die 102 in an alternative embodiment of a manufactured version of a package similar to the embodiment of the package 200 as shown in Figures 2A and 2B of the present disclosure.

After the seventh step 814 in which the resin 116 is formed on the one or more sidewalls 108 of the die 102 and the one or more sidewalls 114 of the dielectric layer 110, in the eighth step the one or more dielectric layers 126 are formed on the third surface 118 of the resin 116 and on the surface 124 of the dielectric layer 110. In tandem with forming the one or more dielectric layers 126, the one or more conductive connection structures 130 are formed along the one or more dielectric layers 126. For example, a first dielectric layer of the one or more dielectric layers 126 is formed on the surface 124 of the dielectric layer 110 and the third surface 118 of the resin 116. The first dielectric layer is then patterned with first openings and a conductive material then is deposited to fill those first openings. The conductive material is then allowed to cure, which forms the traces 130a of the conductive connection structures 130. After the first dielectric layer of the one or more dielectric layers 126 and the traces 130a of the conductive structures 130 have been formed, a second dielectric layer of the one or more dielectric layers 126 is formed on the first dielectric layer of the one or more dielectric layers 126 and on the traces 130a of the conductive connection structures 130. The second dielectric layer is then patterned with second openings that expose regions of the traces 130a of the conductive connection structures 130. A conductive material is then deposited and filled within the second openings. The conductive material within the second openings in the second dielectric layer of the one or more dielectric layers 126 is then allowed to cure forming the studs 130b of the conductive connection structures 130. Once the studs 130b are formed, the conductive connection elements have been formed. The results of the seventh step 814 and the eighth step 816 may readily be seen in the cross-sectional view of the structure as shown in Figure 15D.

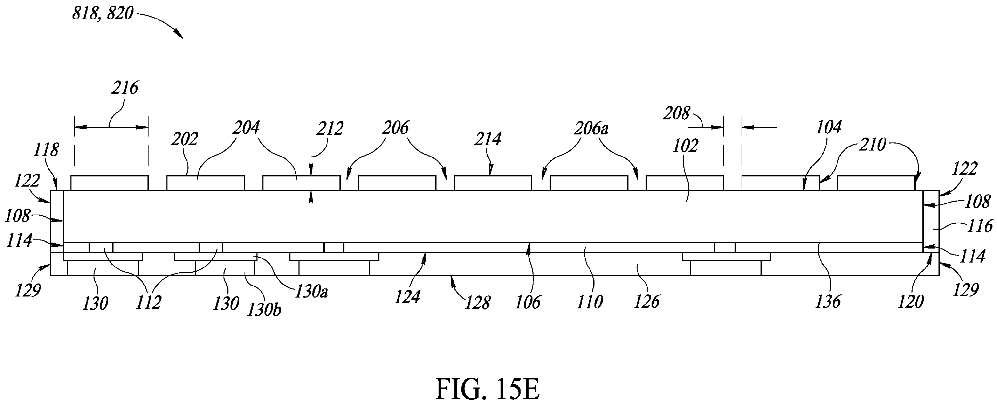

After the eighth step 816 in which the one or more dielectric layers 126 and the conductive connection structures 130 are formed, in the ninth step 818 the structure as shown in Figure 15D is removed from the support 826. After the ninth step 818 in which the structure as shown in Figure 15D has been removed from the support 826, in the tenth step 820 any remaining amount of the temporary layer 822 and the additional temporary layer 828 is removed from the third surface 118 of the resin 116 and from the first surface 104 of the die 102 exposing the plurality of channels 206 extending between the plurality of separate and distinct heat sinks 204. The temporary layer 822 and the additional temporary layer 828 may be soluble materials that deteriorate or dissolve when exposed to a liquid or gas, or may deteriorate and dissolve when exposed to a light source. In other words, after the tenth step 820, the package 200 has been manufactured as shown in **Figure 15E** of the present disclosure.

As discussed herein, the one or more embodiments of the packages 200, 300, 304, 308, 312, 400, 500, which all include the plurality of separate and distinct heat sinks, slugs, or spreaders 204 that are separate and distinct from each other, further mitigate the thermomechanical stresses that occur when the packages 200, 300, 304, 308, 312, 400, 500 are exposed to increases or decreases in temperature as compared to the package 100 with the heat sink, slug, or spreader 131. For example, the plurality of separate and distinct heat sinks, slugs, or spreaders 204 further mitigates the thermomechanical stresses in the packages 200, 300, 304, 308, 312, 400, 500 generated by increases or decreases of temperatures by having the plurality of separate and distinct heat sinks, slugs, or spreaders 204. This is because these separate and distinct heat sinks, slugs, or spreaders 204 prevents or further reduce the likelihood of defects propagating within the packages 200, 300, 304, 308, 312, 400, 500 due to these thermomechanical stresses being more evenly distributed across the interface 136. Preventing or further reducing the likelihood of defects by providing the plurality of separate and distinct heat sinks, slugs, or spreaders 204 further increases the usable life span of the packages 200, 300, 304, 308, 312, 400, 500 such that the packages 200, 300, 304, 308, 312, 400, 500 function within selected tolerances for a longer period of time as compared to the package 100 including the heat sink, slug, or spreader 131 made of the continuous layer of conductive material. The plurality of separate and distinct heat sinks 204 also provides similar heat dissipation efficiency as the heat sink, slug, or spreader 131, and the heat dissipation efficiency may be further increased by providing the thermally conductive material 402, which has the high modulus of elasticity, within the plurality of channels 206.

The various embodiments of the plurality of separate and distinct heat sinks, spreaders, or slugs 204, 302, 306, 310, 314 may be utilized in various types of semiconductor packages in which heat dissipation improves functionality and increases usable the life span of the respective semiconductor package.

## Claims

1. A device, comprising:
∘ a die (102) including a first surface (104), a second surface (106) opposite to the first surface, and one or more sidewalls (108) transverse to the first surface (104) and the second surface (106), the one or more sidewalls (108) extending from the first surface (104) to the second surface (106);
∘ a first non-conductive layer (110) on the second surface (106) of the die (102);
• the first non-conductive layer (110) including one or more sidewalls (114) coplanar with the one or more sidewalls (108) of the die (102);
∘ a resin (116) covering the one or more sidewalls (108) of the die (102) and extending around the die (102), and covering the one or more sidewalls (114) of the first non-conductive layer (110);
∘ a plurality of conductive vias (112) extending through the first non-conductive layer (110) to the die (102);
∘ a plurality of conductive connection structures (130) coupled to the plurality of conductive vias (112) and on the first non-conductive layer (110), the plurality of conductive connection structures (130) including a plurality of end surfaces spaced apart from the plurality of conductive vias (112);
∘ a second non-conductive layer (126) being on the first non-conductive layer (110) and extending around the plurality of conductive connection structures (130), and wherein the plurality of end surfaces of the plurality of conductive connection structures (130) is exposed from the second non-conductive layer (126);
∘ a plurality of heat sinks (204, 302, 306, 310, 314) on the first surface (104) of the die (102), each respective heat sink of the plurality of heat sinks (204, 302, 306, 310, 314) being separate and distinct from adjacent heat sinks of the plurality of heat sinks (204, 302, 306, 310, 314); and
∘ a plurality of channels (206, 303, 307, 311, 315) separating each respective heat sink of the plurality of heat sinks (204, 302, 306, 310, 314) from adjacent heat sinks of the plurality of heat sinks (204, 302, 306, 310, 314);
∘ wherein each respective channel of the plurality of channels (206, 303, 307, 311, 315) has a distance that extends between sidewalls (210) of adjacent heat sinks of the plurality of heat sinks (204), and the distance ranges from 10 to 350 micrometers (µm) or is equal to the upper and lower ends of this range.

2. The device of claim 1, wherein the plurality of channels (206) includes:
a plurality of first channels (206a) extending in a first direction; and
a plurality of second channels (206b) extending in a second direction transverse to the first direction.

3. The device of claim 2, wherein:
the plurality of first channels (206a) is perpendicular to the plurality of second channels (206b); and
each respective heat sink of the plurality of heat sinks (204) has a rectangular prism shape.

4. The device of claim 2, wherein:
the plurality of first channels (206a) is perpendicular to the plurality of second channels (206b); and
each respective heat sink of the plurality of heat sinks (204) has a cuboid shape.

5. The device of claim 1, wherein respective heat sinks of the plurality of heat sinks (204,303, 307, 311, 315) have at least one of the following of a cylindrical prism shape, a rectangular prism shape, and a diamond prism shape.

6. The device of claim 1, wherein each respective heat sink of the plurality of heat sinks (204, 303, 307, 311, 315) includes:
a heat sink end surface (214) spaced apart from first surface (104) of the die (102); and
a thickness that extends from first surface (104) to the heat sink end surface (214), the thickness ranging from 20 to 200 micrometers (µm) or being equal to the upper and lower ends of this range.

7. The device of claim 1, wherein respective heat sinks of the plurality of heat sinks (204, 303, 307, 311, 315) are on a third surface of the resin (116).

8. The device of claim 7, wherein the third surface (118) of the resin (116) is coplanar with the first surface (104) of the die (102).

9. The device of claim 1, wherein the plurality of heat sinks (204, 303, 307, 311, 315) is spaced inward from one or more sidewalls (122) of the resin (116).

10. The device of claim 1, wherein a thermally conductive material (402) fills the plurality of the channels (206, 303, 307, 311, 315) and is on the surface (104) of the die (102).

11. The device of claim 10, wherein the thermally conductive material (402) is elastic.

12. The device of claim 11, wherein the thermally conductive material (402) has a modulus of elasticity within the range of 0.1 to 5000 MPa or equal to the upper and lower ends of this range.

13. The device of claim 10, wherein the thermally conductive material (402) filling the plurality of channels (206) has a thermally conductive surface (404) coplanar with the heat sink end surfaces (214) of the plurality of heat sinks (204).

14. A method, comprising:
forming a temporary layer (712) covering a first surface (104) of a die (102);
removing portions of the temporary layer (712) forming a plurality of openings (714) in the temporary layer (712) exposing areas of the first surface (104) of the die (102);
depositing a first thermally conductive material in the plurality of openings (714) forming a plurality of separate and distinct heat sinks (204, 303, 307, 311, 315) by at least partially filling the plurality of openings with the first thermally conductive material; and
removing one or more remaining portions of the temporary layer (712) exposing sidewalls of the plurality of separate and distinct heat sinks (204, 303, 307, 311, 315) exposing a plurality of channels (206, 303, 307, 311, 315) extending between adjacent heat sinks of the plurality of separate and distinct heat sinks;
forming a first non-conductive layer (110) on a second surface of the die opposite to the first surface;
forming a plurality of conductive vias (112) extending through the first non-conductive layer to the second surface of the die;
forming a resin (116) around the die and covering sidewalls of the die;
forming a plurality of conductive connection structures (130) on the first non-conductive layer and on the resin; and
forming a second non-conductive layer (126) extending around the plurality of conductive connection structures;
wherein the first non-conductive layer (110) includes one or more sidewalls (114) coplanar with one or more sidewalls (108) of the die (102);
wherein the resin covers one or more sidewalls (108) of the die (102) and extends around the die (102), and covers the one or more sidewalls (114) of the first non-conductive layer (110);
wherein each respective channel of the plurality of channels (206, 303, 307, 311, 315) has a distance that extends between sidewalls (210) of adjacent heat sinks of the plurality of heat sinks (204), and the distance ranges from 10 to 350 micrometers (µm) or is equal to the upper and lower ends of this range.

15. The method of claim 14, further comprising forming a second thermally conductive material that has an elasticity ranging from 0.1 to 5000 MPa or equal to the upper and lower ends of this range within the plurality of channels and on the first surface of the die.

16. The method of claim 14, wherein respective heat sinks of the plurality of heat sinks have at least one of the following of a cylindrical prism shape, a rectangular prism shape, and a diamond prism shape.

## Patentansprüche

1. Vorrichtung, die Folgendes umfasst:
∘ einen Chip (102), der eine erste Oberfläche (104), eine der ersten Oberfläche gegenüberliegende zweite Oberfläche (106) und eine oder mehrere Seitenwände (108), die quer zu der ersten Oberfläche (104) und zu der zweiten Oberfläche (106) verlaufen, einschließt, wobei sich die eine oder die mehreren Seitenwände (108) von der ersten Oberfläche (104) zu der zweiten Oberfläche (106) erstrecken;
∘ eine erste nichtleitfähige Schicht (110) auf der zweiten Oberfläche (106) des Chips (102);
• wobei die erste nichtleitfähige Schicht (110) eine oder mehrere Seitenwände (114) einschließt, die koplanar mit der einen oder den mehreren Seitenwänden (108) des Chips (102) sind;
∘ ein Harz (116), das die eine oder die mehreren Seitenwände (108) des Chips (102) bedeckt und sich um den Chip (102) herum erstreckt und die eine oder die mehreren Seitenwände (114) der ersten nichtleitfähigen Schicht (110) bedeckt;
∘ eine Vielzahl von leitfähigen Vias (112), die sich durch die erste nichtleitfähige Schicht (110) bis zu dem Chip (102) erstrecken;
∘ eine Vielzahl von leitfähigen Verbindungsstrukturen (130), die mit der Vielzahl von leitfähigen Vias (112) gekoppelt sind und sich auf der ersten nichtleitfähigen Schicht (110) befinden, wobei die Vielzahl von leitfähigen Verbindungsstrukturen (130) eine Vielzahl von Endflächen einschließen, die von der Vielzahl von leitfähigen Vias (112) beabstandet sind;
∘ eine zweite nichtleitfähige Schicht (126), die sich auf der ersten nichtleitfähigen Schicht (110) befindet und sich um die Vielzahl von leitfähigen Verbindungsstrukturen (130) erstreckt, und wobei die Vielzahl von Endflächen der Vielzahl von leitfähigen Verbindungsstrukturen (130) von der zweiten nichtleitfähigen Schicht (126) freigelegt ist;
∘ eine Vielzahl von Kühlkörpern (204, 302, 306, 310, 314) auf der ersten Oberfläche (104) des Chips (102), wobei jeder jeweilige Kühlkörper der Vielzahl von Kühlkörpern (204, 302, 306, 310, 314) von benachbarten Kühlkörpern der Vielzahl von Kühlkörpern (204, 302, 306, 310, 314) getrennt und verschieden sind; und
∘ eine Vielzahl von Kanälen (206, 303, 307, 311, 315), die jeden jeweiligen Kühlkörper der Vielzahl von Kühlkörpern (204, 302, 306, 310, 314) von benachbarten Kühlkörpern der Vielzahl von Kühlkörpern (204, 302, 306, 310, 314) trennen;
∘ wobei jeder jeweilige Kanal der Vielzahl von Kanälen (206, 303, 307, 311, 315) einen Abstand aufweist, der sich zwischen Seitenwänden (210) benachbarter Kühlkörper der Vielzahl von Kühlkörpern (204) erstreckt, und der Abstand zwischen 10 und 350 Mikrometern (µm) liegt oder den oberen und unteren Enden dieses Bereichs entspricht.

2. Vorrichtung nach Anspruch 1, wobei die Vielzahl von Kanälen (206) einschließt:
eine Vielzahl von ersten Kanälen (206a), die sich in einer ersten Richtung erstrecken; und
eine Vielzahl von zweiten Kanälen (206b), die sich in einer zweiten Richtung quer zu der ersten Richtung erstrecken.

3. Vorrichtung nach Anspruch 2, wobei:
die Vielzahl von ersten Kanälen (206a) senkrecht zu der Vielzahl von zweiten Kanälen (206b) verläuft; und
jeder jeweilige Kühlkörper der Vielzahl von Kühlkörpern (204) eine rechteckige Prismenform aufweist.

4. Vorrichtung nach Anspruch 2, wobei:
die Vielzahl von ersten Kanälen (206a) senkrecht zu der Vielzahl von zweiten Kanälen (206b) verläuft; und
jeder jeweilige Kühlkörper der Vielzahl von Kühlkörpern (204) eine Quaderform aufweist.

5. Vorrichtung nach Anspruch 1, wobei die jeweiligen Kühlkörper der Vielzahl von Kühlkörpern (204, 303, 307, 311, 315) mindestens eine der folgenden einer zylindrischen Prismenform, einer rechteckigen Prismenform und einer diamantenförmigen Prismenform aufweisen.

6. Vorrichtung nach Anspruch 1, wobei jeder jeweilige Kühlkörper der Vielzahl von Kühlkörpern (204, 303, 307, 311, 315) einschließt:
eine Kühlkörper-Endfläche (214), die von der ersten Oberfläche (104) des Chips (102) beabstandet ist; und
eine Dicke, die sich von der ersten Oberfläche (104) bis zu der Kühlkörper-Endfläche (214) erstreckt, wobei die Dicke zwischen 20 und 200 Mikrometer (µm) liegt oder den oberen und unteren Enden dieses Bereichs entspricht.

7. Vorrichtung nach Anspruch 1, wobei sich die jeweiligen Kühlkörper der Vielzahl von Kühlkörpern (204, 303, 307, 311, 315) auf einer dritten Oberfläche des Harzes (116) befinden.

8. Vorrichtung nach Anspruch 7, wobei die dritte Oberfläche (118) des Harzes (116) koplanar mit der ersten Oberfläche (104) des Chips (102) ist.

9. Vorrichtung nach Anspruch 1, wobei die Vielzahl von Kühlkörpern (204, 303, 307, 311, 315) von einer oder mehreren Seitenwänden (122) des Harzes (116) nach innen beabstandet sind.

10. Vorrichtung nach Anspruch 1, wobei ein wärmeleitfähiges Material (402) die Vielzahl der Kanäle (206, 303, 307, 311, 315) füllt und sich auf der Oberfläche (104) des Chips (102) befindet.

11. Vorrichtung nach Anspruch 10, wobei das wärmeleitfähige Material (402) elastisch ist.

12. Vorrichtung nach Anspruch 11, wobei das wärmeleitfähige Material (402) einen Elastizitätsmodul im Bereich von 0,1 bis 5000 MPa oder gleich den oberen und unteren Enden dieses Bereichs aufweist.

13. Vorrichtung nach Anspruch 10, wobei das wärmeleitfähige Material (402), das die Vielzahl von Kanälen (206) füllt, eine wärmeleitfähige Oberfläche (404) aufweist, die koplanar mit den Kühlkörper-Endflächen (214) der Vielzahl von Kühlkörpern (204) ist.

14. Verfahren, umfassend:
Bilden einer temporären Schicht (712), die eine erste Oberfläche (104) eines Chips (102) bedeckt;
Entfernen von Abschnitten der temporären Schicht (712), die eine Vielzahl von Öffnungen (714) in der temporären Schicht (712) bilden, die Bereiche der ersten Oberfläche (104) des Chips (102) freilegen;
Abscheiden eines ersten wärmeleitfähigen Materials in die Vielzahl von Öffnungen (714) zum Bilden einer Vielzahl von getrennten und verschiedenen Kühlkörpern (204, 303, 307, 311, 315) durch das mindestens teilweise Füllen der Vielzahl von Öffnungen mit dem ersten wärmeleitfähigen Material; und
Entfernen eines oder mehrerer verbleibender Abschnitte der temporären Schicht (712), wodurch Seitenwände der Vielzahl von getrennten und verschiedenen Kühlkörpern (204, 303, 307, 311, 315) freigelegt werden, wodurch eine Vielzahl von Kanälen (206, 303, 307, 311, 315) freigelegt werden, die sich zwischen benachbarten Kühlkörpern der Vielzahl von getrennten und verschiedenen Kühlkörpern erstrecken;
Bilden einer ersten nichtleitfähigen Schicht (110) auf einer zweiten Oberfläche des Chips gegenüber der ersten Oberfläche;
Bilden einer Vielzahl von leitfähigen Vias (112), die sich durch die erste nichtleitfähige Schicht bis zu der zweiten Oberfläche des Chips erstrecken;
Bilden eines Harzes (116) um den Chip herum und Bedecken von Seitenwänden des Chips;
Bilden einer Vielzahl von leitfähigen Verbindungsstrukturen (130) auf der ersten nichtleitfähigen Schicht und auf dem Harz; und
Bilden einer zweiten nichtleitfähigen Schicht (126), die sich um die Vielzahl von leitfähigen Verbindungsstrukturen herum erstreckt;
wobei die erste nichtleitfähige Schicht (110) eine oder mehrere Seitenwände (114) einschließt, die koplanar mit einer oder mehreren Seitenwänden (108) des Chips (102) sind;
wobei das Harz eine oder mehrere Seitenwände (108) des Chips (102) bedeckt und sich um den Chip (102) herum erstreckt und die eine oder die mehreren Seitenwände (114) der ersten nichtleitfähigen Schicht (110) bedeckt;
wobei jeder jeweilige Kanal der Vielzahl von Kanälen (206, 303, 307, 311, 315) einen Abstand aufweist, der sich zwischen Seitenwänden (210) benachbarter Kühlkörper der Vielzahl von Kühlkörpern (204) erstreckt, und der Abstand zwischen 10 und 350 Mikrometern (µm) liegt oder den oberen und unteren Enden dieses Bereichs entspricht.

15. Verfahren nach Anspruch 14, ferner umfassend das Bilden eines zweiten wärmeleitfähigen Materials, das eine Elastizität im Bereich von 0,1 bis 5000 MPa oder gleich den oberen und unteren Enden dieses Bereichs innerhalb der Vielzahl von Kanälen und auf der ersten Oberfläche des Chips aufweist.

16. Verfahren nach Anspruch 14, wobei die jeweiligen Kühlkörper der Vielzahl von Kühlkörpern mindestens eine der folgenden einer zylindrischen Prismenform, einer rechteckigen Prismenform und einer diamantenförmigen Prismenform aufweisen.

## Revendications

1. **Dispositif,** comprenant :
∘ une puce (102) comportant une première surface (104), une deuxième surface (106) opposée à la première surface, et une ou plusieurs parois latérales (108) transversales à la première surface (104) et à la deuxième surface (106), la ou les parois latérales (108) s'étendant de la première surface (104) à la deuxième surface (106) ;
∘ une première couche non conductrice (110) sur la deuxième surface (106) de la puce (102) ;
• la première couche non conductrice (110) comportant une ou plusieurs parois latérales (114) coplanaires avec la ou les parois latérales (108) de la puce (102) ;
∘ une résine (116) recouvrant la ou les parois latérales (108) de la puce (102) et s'étendant autour de la puce (102), et recouvrant la ou les parois latérales (114) de la première couche non conductrice (110) ;
∘ une pluralité de vias conducteurs (112) s'étendant à travers la première couche non conductrice (110) jusqu'à la puce (102) ;
∘ une pluralité de structures de connexion conductrices (130) couplées à la pluralité de vias conducteurs (112) et sur la première couche non conductrice (110), la pluralité de structures de connexion conductrices (130) comportant une pluralité de surfaces d'extrémité espacées de la pluralité de vias conducteurs (112) ;
∘ une seconde couche non conductrice (126) étant sur la première couche non conductrice (110) et s'étendant autour de la pluralité de structures de connexion conductrices (130), et dans lequel la pluralité de surfaces d'extrémité de la pluralité de structures de connexion conductrices (130) est exposée à partir de la seconde couche non conductrice (126) ;
∘ une pluralité de dissipateurs thermiques (204, 302, 306, 310, 314) sur la première surface (104) de la puce (102), chaque dissipateur thermique respectif de la pluralité de dissipateurs thermiques (204, 302, 306, 310, 314) étant séparé et distinct des dissipateurs thermiques adjacents de la pluralité de dissipateurs thermiques (204, 302, 306, 310, 314) ; et
∘ une pluralité de canaux (206, 303, 307, 311, 315) séparant chaque dissipateur thermique respectif de la pluralité de dissipateurs thermiques (204, 302, 306, 310, 314) de dissipateurs thermiques adjacents de la pluralité de dissipateurs thermiques (204, 302, 306, 310, 314) ;
∘ dans lequel chaque canal respectif de la pluralité de canaux (206, 303, 307, 311, 315) présente une distance qui s'étend entre les parois latérales (210) de dissipateurs thermiques adjacents de la pluralité de dissipateurs thermiques (204), et la distance est dans une plage de 10 à 350 micromètres (µm) ou est égale aux extrémités supérieure et inférieure de cette plage.

2. Dispositif selon la revendication 1, dans lequel la pluralité de canaux (206) comporte :
une pluralité de premiers canaux (206a) s'étendant dans une première direction ; et
une pluralité de seconds canaux (206b) s'étendant dans une seconde direction transversale à la première direction.

3. Dispositif selon la revendication 2, dans lequel :
la pluralité de premiers canaux (206a) est perpendiculaire à la pluralité de seconds canaux (206b) ; et
chaque dissipateur thermique respectif de la pluralité de dissipateurs thermiques (204) présente une forme de prisme rectangulaire.

4. Dispositif selon la revendication 2, dans lequel :
la pluralité de premiers canaux (206a) est perpendiculaire à la pluralité de seconds canaux (206b) ; et
chaque dissipateur thermique respectif de la pluralité de dissipateurs thermiques (204) présente une forme de pavé droit.

5. Dispositif selon la revendication 1, dans lequel les dissipateurs thermiques respectifs de la pluralité de dissipateurs thermiques (204, 303, 307, 311, 315) présentent au moins l'une parmi une forme de prisme cylindrique, une forme de prisme rectangulaire et une forme de prisme en losange.

6. Dispositif selon la revendication 1, dans lequel chaque dissipateur thermique respectif de la pluralité de dissipateurs thermiques (204, 303, 307, 311, 315) comporte :
une surface d'extrémité de dissipateur thermique (214) espacée de la première surface (104) de la puce (102) ; et
une épaisseur s'étendant de la première surface (104) à la surface d'extrémité de dissipateur thermique (214), l'épaisseur étant dans une plage de 20 à 200 micromètres (µm) ou étant égale aux extrémités supérieure et inférieure de cette plage.

7. Dispositif selon la revendication 1, dans lequel des dissipateurs thermiques respectifs de la pluralité de dissipateurs thermiques (204, 303, 307, 311, 315) sont sur une troisième surface de la résine (116).

8. Dispositif selon la revendication 7, dans lequel la troisième surface (118) de la résine (116) est coplanaire avec la première surface (104) de la puce (102).

9. Dispositif selon la revendication 1, dans lequel la pluralité de dissipateurs thermiques (204, 303, 307, 311, 315) est espacée vers l'intérieur à partir d'une ou plusieurs parois latérales (122) de la résine (116).

10. Dispositif selon la revendication 1, dans lequel un matériau thermoconducteur (402) remplit la pluralité de canaux (206, 303, 307, 311, 315) et se trouve sur la surface (104) de la puce (102).

11. Dispositif selon la revendication 10, dans lequel le matériau thermoconducteur (402) est élastique.

12. Dispositif selon la revendication 11, dans lequel le matériau thermoconducteur (402) présente un module d'élasticité dans la plage de 0,1 à 5000 MPa ou égal aux extrémités supérieure et inférieure de cette plage.

13. Dispositif selon la revendication 10, dans lequel le matériau thermoconducteur (402) remplissant la pluralité de canaux (206) présente une surface thermoconductrice (404) coplanaire avec les surfaces d'extrémité de dissipateur thermique (214) de la pluralité de dissipateurs thermiques (204).

14. Procédé, comprenant :
la formation d'une couche temporaire (712) recouvrant une première surface (104) d'une puce (102) ;
le retrait de parties de la couche temporaire (712) formant une pluralité d'ouvertures (714) dans la couche temporaire (712) exposant des zones de la première surface (104) de la puce (102) ;
le dépôt d'un premier matériau thermoconducteur dans la pluralité d'ouvertures (714) formant une pluralité de dissipateurs thermiques (204, 303, 307, 311, 315) séparés et distincts en remplissant au moins partiellement la pluralité d'ouvertures avec le premier matériau thermoconducteur ; et
le retrait d'une ou plusieurs parties restantes de la couche temporaire (712) exposant des parois latérales de la pluralité de dissipateurs thermiques (204, 303, 307, 311, 315) séparés et distincts exposant une pluralité de canaux (206, 303, 307, 311, 315) s'étendant entre des dissipateurs thermiques adjacents de la pluralité de dissipateurs thermiques séparés et distincts ;
la formation d'une première couche non conductrice (110) sur une deuxième surface de la puce opposée à la première surface ;
la formation d'une pluralité de vias conducteurs (112) s'étendant à travers la première couche non conductrice jusqu'à la deuxième surface de la puce ;
la formation d'une résine (116) autour de la puce et recouvrant des parois latérales de la puce ;
la formation d'une pluralité de structures de connexion conductrices (130) sur la première couche non conductrice et sur la résine ; et
la formation d'une seconde couche non conductrice (126) s'étendant autour de la pluralité de structures de connexion conductrices ;
dans lequel la première couche non conductrice (110) comporte une ou plusieurs parois latérales (114) coplanaires avec une ou plusieurs parois latérales (108) de la puce (102) ;
dans lequel la résine recouvre une ou plusieurs parois latérales (108) de la puce (102) et s'étend autour de la puce (102), et recouvre la ou les parois latérales (114) de la première couche non conductrice (110) ;
dans lequel chaque canal respectif de la pluralité de canaux (206, 303, 307, 311, 315) présente une distance qui s'étend entre les parois latérales (210) de dissipateurs thermiques adjacents de la pluralité de dissipateurs thermiques (204), et la distance est dans une plage de 10 à 350 micromètres (µm) ou est égale aux extrémités supérieure et inférieure de cette plage.

15. Procédé selon la revendication 14, comprenant en outre la formation d'un second matériau thermoconducteur qui présente une élasticité dans une plage de 0,1 à 5000 MPa ou égale aux extrémités supérieure et inférieure de cette plage au sein de la pluralité de canaux et sur la première surface de la puce.

16. Procédé selon la revendication 14, dans lequel les dissipateurs thermiques respectifs de la pluralité de dissipateurs thermiques présentent au moins l'une parmi une forme de prisme cylindrique, une forme de prisme rectangulaire et une forme de prisme en losange.
